# EUROPEAN PATENT APPLICATION

(11) **EP 4 524 284 A2**
(43) Date of publication of application: **19.03.2025**
(21) Application number: 24196672.0
(22) Date of filing: 27.08.2024
(51) Int. Cl.: C23C 14/12, C23C 14/24

(54) **EVAPORATION DEVICE**

(30) Priority: 08.09.2023 KR 20230119459
(71) Applicant: Samsung Display Co., Ltd., Gyeonggi-do (KR)
(72) Inventor: HAN, Inae, Yongin-si (KR); HAN, Jongbun, Yongin-si (KR); KIM, Hyunjae, Yongin-si (KR); KIM, Hundong, Yongin-si (KR)
(74) Representative: Marks & Clerk LLP

(57) **Abstract**

An evaporation device includes a first deposition source, a second deposition source in a first direction together with the first deposition source, a body part spaced apart from the first and second deposition sources in a second direction intersecting the first direction and including a first portion and a second portion in the second direction, a nozzle body part on the body part, a first pipe connected to a side surface of the first deposition source facing the body part and the nozzle body part and a lower end of the first portion, a second pipe connected to a side surface of the second deposition source facing the body part and the nozzle body part and a lower end of the second portion, a first nozzle protruding upward from the nozzle body part, and a second nozzle protruding upward from the nozzle body part.

## Description

### BACKGROUND

### 1. Technical Field

Embodiments described herein relate to an evaporation device.

### 2. Description of the Related Art

Organic light emitting diode displays (OLEDs) having excellent luminance characteristics and viewing angle characteristics have attracted attention as next-generation flat panel display devices. The organic light emitting diode displays may be manufactured to be light and thin because separate light sources are not required. The organic light emitting diode displays have characteristics such as low power consumption, high luminance, high response speed, and the like.

An organic light emitting diode display may include light emitting elements, each of which may include an anode, an emissive layer, and a cathode. The emissive layer may be disposed between the anode and the cathode. The emissive layer receives holes from the anode and electrons from the cathode. The holes and electrons injected into the emissive layer may be combined to form excitons, and the light emitting element may emit light as the excitons transition to a ground state.

An evaporation device is used to form emissive layers on a substrate. In general, the emissive layers are formed by mixing a host and a dopant. The evaporation device may include deposition sources filled with the host and the dopant, respectively. Each of the deposition sources may include a crucible filled with a deposition material (for example, a host or dopant) and a nozzle through which the deposition material is dispensed.

The host and the dopant are dispensed from the deposition sources and deposited on the substrate. The emissive layers are formed by mixing the host and the dopant at a selectable ratio. The mixing ratio between the host and the dopant has to be constant on the entire substrate such that the emissive layers formed on the substrate have the same characteristics. However, since the nozzles of the deposition sources are spaced apart from each other, the mixing ratio between the host and the dopant may not be constant depending on the distributions of the deposition materials dispensed from the deposition sources.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Embodiments provide an evaporation device for providing deposition materials on a substrate such that the mixing ratio between the deposition materials is constant.

According to an embodiment, an evaporation device may include a first deposition source; a second deposition source disposed in a first direction together with the first deposition source; a body part spaced apart from the first deposition source and the second deposition source in a second direction intersecting the first direction and including a first portion and a second portion disposed in the second direction; a nozzle body part disposed on the body part; a first pipe connected to a side surface of the first deposition source facing the body part and the nozzle body part and a lower end of the first portion; a second pipe connected to a side surface of the second deposition source facing the body part and the nozzle body part and a lower end of the second portion; a first nozzle protruding upward from the nozzle body part; and a second nozzle protruding upward from the nozzle body part.

The first nozzle and the second nozzle may be disposed in the first direction.

The evaporation device may include a first pipe passage defined in the first pipe, and a first passage continuous with the first pipe passage defined in the first portion, and a second pipe passage defined in the second pipe, and a second passage continuous with the second pipe passage defined in the second portion.

The evaporation device may include a first nozzle passage continuous with the first passage and a second nozzle passage continuous with the second passage defined in the nozzle body part, and a first opening continuous with the first nozzle passage defined in the first nozzle, and a second opening continuous with the second nozzle passage defined in the second nozzle.

The first pipe may include a first-first pipe connected to an upper portion of the side surface of the first deposition source and extending downward; and a first-second pipe connected to a lower portion of the first-first pipe and the lower end of the first portion, and the second pipe may include: a second-first pipe connected to an upper portion of the side surface of the second deposition source and extending downward; and a second-second pipe connected to a lower portion of the second-first pipe and the lower end of the second portion.

The evaporation device may further comprise a third deposition source; and a fourth deposition source disposed in the first direction together with the third deposition source, wherein the third deposition source and the fourth deposition source are spaced apart from the first deposition source and the second deposition source in the second direction, and the body part and the nozzle body part are disposed between the first deposition source and the second deposition source and the third deposition source and the fourth deposition source.

Different deposition materials may be accommodated in the first deposition source, the second deposition source, the third deposition source, and the fourth deposition source, respectively.

The evaporation device may further comprise a third pipe connected to a side surface of the third deposition source facing the body part and the nozzle body part and a lower end of the body part; a fourth pipe connected to a side surface of the fourth deposition source facing the body part and the nozzle body part and the lower end of the body part; a third nozzle protruding upward from the nozzle body part; and a fourth nozzle protruding upward from the nozzle body part.

The third nozzle and the fourth nozzle may be disposed in the first direction and disposed adjacent to the first nozzle and the second nozzle in the second direction, respectively.

The third nozzle and the fourth nozzle may directly contact the first nozzle and the second nozzle in the second direction, respectively.

The body part may further include a third portion and a fourth portion disposed in the second direction together with the first portion and the second portion, and the third pipe may be connected to a lower end of the third portion, and the fourth pipe may be connected to a lower end of the fourth portion.

The evaporation device may include a third pipe passage defined in the third pipe, and a third passage continuous with the third pipe passage defined in the third portion, a fourth pipe passage defined in the fourth pipe, and a fourth passage continuous with the fourth pipe passage defined in the fourth portion, a third nozzle passage continuous with the third passage and a fourth nozzle passage continuous with the fourth passage defined in the nozzle body part, and a third opening continuous with the third nozzle passage defined in the third nozzle, and a fourth opening continuous with the fourth nozzle passage defined in the fourth nozzle.

The first nozzle, the second nozzle, the third nozzle, and the fourth nozzle may be disposed in the first direction.

The evaporation device may further comprise a fifth deposition source spaced apart from the first deposition source and the second deposition source in the second direction; and a fifth nozzle connected to an upper end of the fifth deposition source, wherein the first deposition source and the second deposition source are disposed between the body part and the fifth deposition source.

The evaporation device may further comprise a third deposition source disposed in the first direction together with the first deposition source and the second deposition source; a third pipe connected to the third deposition source and a third portion of the body part; a third nozzle protruding upward from the nozzle body part; a fourth deposition source spaced apart from the nozzle body part in the second direction; and a plurality of fourth nozzles connected to an upper end of the fourth deposition source and disposed in the first direction, wherein the body part is disposed between the first deposition source, the second deposition source, and the third deposition source and the fourth deposition source.

The first nozzle, the second nozzle, and the third nozzle may be disposed in the first direction, and the plurality of fourth nozzles are obliquely disposed to face toward the first nozzle, the second nozzle, and the third nozzle.

The evaporation device may further comprise a third deposition source; a fourth deposition source; a third pipe connected to the third deposition source and the body part; a fourth pipe connected to the fourth deposition source and the body part; a third nozzle protruding upward from the nozzle body part; and a fourth nozzle protruding upward from the nozzle body part, wherein the first deposition source, the second deposition source, the third deposition source, and the fourth deposition source are disposed in the first direction.

The evaporation device may further comprise a third deposition source; a fourth deposition source disposed in the first direction together with the third deposition source; a third pipe connected to the third deposition source; a fourth pipe connected to the fourth deposition source; and a third nozzle and a fourth nozzle disposed in the first direction, wherein the body part may include a first body part connected to the first pipe and the second pipe; and a second body part connected to the third pipe and the fourth pipe, the nozzle body part may include a first nozzle body part from which the first nozzle and the second nozzle protrude, the first nozzle body part being disposed on the first body part; and a second nozzle body part disposed on the second body part, the third nozzle and the fourth nozzle protrude upward from the second nozzle body part, and the first body part is disposed between the first deposition source and the second deposition source and the second body part in the second direction, and the second body part is disposed between the first body part and the third deposition source and the fourth deposition source in the second direction.

The first nozzle and the second nozzle and the third nozzle and the fourth nozzle may be obliquely disposed to face toward each other.

According to an embodiment, an evaporation device may include a first deposition source; a second deposition source disposed in a first direction together with the first deposition source; a first nozzle; a body part spaced apart from the first deposition source and the second deposition source in a second direction intersecting the first direction and that may include a first portion having a first passage defined in the first portion and a second portion having a second passage defined in the second portion; a first pipe connected to a side surface of the first deposition source facing the body part and a lower portion of the body part, the first pipe having a first pipe passage continuous with the first passage; a second pipe connected to a side surface of the second deposition source facing the body part and a lower portion of the body part, the second pipe having a second pipe passage continuous with the second passage; a nozzle body part disposed on the body part and that has a first nozzle passage continuous with the first passage and a second nozzle passage continuous with the second passage ; a first nozzle protruding upward from the nozzle body part and that has a first opening continuous with the first nozzle passage ; and a second nozzle protruding upward from the nozzle body part and that has a second opening continuous with the second nozzle passage.

According to an embodiment, an evaporation device may include a first deposition source; a second deposition source disposed in a first direction together with the first deposition source; a third deposition source spaced apart from the first deposition source in a second direction intersecting the first direction; a fourth deposition source spaced apart from the second deposition source in the second direction and disposed in the first direction together with the third deposition source; a body part disposed between the first deposition source and the second deposition source and the third deposition source and the fourth deposition source; a plurality of pipes connected to the first deposition source, the second deposition source, the third deposition source and the fourth deposition source, respectively, and connected to the body part; a nozzle body part disposed on the body part; and a first nozzle; a second nozzle; a third nozzle; and a fourth nozzle protruding upward from the nozzle body part. The first nozzle and the second nozzle are disposed in the first direction, and the third nozzle and the fourth nozzle are disposed in the first direction and adjacent to the first nozzle and the second nozzle in the second direction.

At least some of the above and other features of the invention are set out in the claims.

### BRIEF DESCRIPTION OF THE DRAWINGS

The above and other objects and features of the disclosure will become apparent by describing in detail embodiments thereof with reference to the accompanying drawings in which:
FIG. 1 is a schematic perspective view of an evaporation device according to an embodiment.
FIG. 2 is a schematic plan view of the evaporation device illustrated in FIG. 1 as viewed from above.
FIG. 3 is a side view of the evaporation device when first and third deposition sources illustrated in FIG. 1 are viewed in a first direction.
FIG. 4 is a side view of the evaporation device when second and fourth deposition sources illustrated in FIG. 1 are viewed in the first direction.
FIG. 5 is a view in which a first-second pipe, a second-second pipe, a third-second pipe, and a fourth-second pipe illustrated in FIGS. 3 and 4 are illustrated on the schematic plan view of FIG. 2 by dotted lines.
FIG. 6 is a schematic plan view separately illustrating the first-second pipe, the second-second pipe, the third-second pipe, and the fourth-second pipe illustrated in FIG. 5.
FIG. 7 is a sectional view taken along line I-I' illustrated in FIG. 5.
FIG. 8 is a sectional view taken along line II-II' illustrated in FIG. 5.
FIG. 9 is a sectional view taken along line III-III' illustrated in FIG. 5.
FIG. 10 is a sectional view taken along line IV-IV' illustrated in FIG. 5.
FIG. 11 is a sectional view taken along line V-V' illustrated in FIG. 5.
FIG. 12 is a sectional view taken along line VI-VI' illustrated in FIG. 10.
FIG. 13 is a sectional view taken along line VII-VII' illustrated in FIG. 11.
FIG. 14 is a view for explaining a deposition process using the evaporation device illustrated in FIG. 1.
FIG. 15 is a view illustrating a section of a pixel including an emissive layer formed by the evaporation device illustrated in FIG. 1.
FIG. 16 is a view for explaining a process of forming the emissive layer using the evaporation device illustrated in FIG. 14.
FIG. 17 illustrates deposition materials dispensed onto a substrate from an evaporation device having a different configuration from the evaporation device illustrated in FIG. 1 and dotted graphs depicting the distributions of the deposition materials.
FIG. 18 illustrates deposition materials dispensed onto a substrate from nozzles of the evaporation device illustrated in FIG. 1 and dotted graphs depicting the distributions of the deposition materials.
FIG. 19 is a view illustrating a planar configuration of an evaporation device according to an embodiment.
FIGS. 20 to 23 are views illustrating sectional configurations of a nozzle body part and first, second, third, and fourth nozzles as viewed in the first direction in FIG. 19.
FIGS. 24 to 27 are views illustrating sectional configurations of the nozzle body part and the first, second, third, and fourth nozzles as viewed in the second direction in FIG. 19.
FIG. 28 is a view illustrating a configuration of an evaporation device according to an embodiment.
FIG. 29 is a sectional view of a light emitting element capable of being formed using the evaporation device illustrated in FIG. 28.
FIG. 30 is a view illustrating a planar configuration of an evaporation device according to an embodiment.
FIG. 31 is a sectional view taken along line VIII-VIII' illustrated in FIG. 30.
FIGS. 32 to 34 are views illustrating sectional configurations of a nozzle body part and first, second, and third nozzles as viewed in the first direction in FIG. 30.
FIGS. 35 to 37 are views illustrating sectional configurations of the nozzle body part and the first, second, and third nozzles as viewed in the second direction in FIG. 30.
FIG. 38 is a view illustrating deposition materials dispensed onto a substrate from the evaporation device illustrated in FIG. 30.
FIG. 39 is a view illustrating a planar configuration of an evaporation device according to an embodiment.
FIG. 40 is a view illustrating a planar configuration of an evaporation device according to an embodiment.
FIG. 41 is a view illustrating deposition materials dispensed onto a substrate from the evaporation device illustrated in FIG. 40.
FIG. 42 is a view illustrating deposition materials dispensed onto a substrate from an evaporation device according to an embodiment.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In this specification, when it is mentioned that a component (or, a region, a layer, a part, etc.) is referred to as being "on", "connected to" or "coupled to" another component, this means that the component may be directly on, connected to, or coupled to the other component or a third component or other components may be present therebetween.

Identical reference numerals refer to identical components. Additionally, in the drawings, the thicknesses, proportions, and dimensions of components may be exaggerated for effective description.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

Terms such as first, second, and the like may be used to describe various components, but the components should not be limited by the terms. The terms may be used only for distinguishing one component from other components. For example, without departing the scope of the disclosure, a first component may be referred to as a second component, and similarly, the second component may also be referred to as the first component.

As used herein, the singular forms, "a," "an," and "the" are intended to include the plural forms as well, unless the context clearly indicates otherwise.

In addition, terms such as "below", "under", "above", and "over" are used to describe a relationship of components illustrated in the drawings. The terms are relative concepts and are described based on directions illustrated in the drawing.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as 'not overlapping' or 'to not overlap' another element, this may include that the elements are spaced apart from each other, offset from each other, or set aside from each other or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, or 5% of the stated value.

Unless otherwise defined, all terms used herein, including technical or scientific terms, have the same meanings as those generally understood by those skilled in the art to which the disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the application.

It should be understood that terms such as "comprise", "include", and "have", and variations thereof, when used herein, specify the presence of stated features, numbers, steps, operations, components, parts, or combinations thereof, but do not preclude the presence or addition of one or more other features, numbers, steps, operations, components, parts, or combinations thereof.

Hereinafter, embodiments will be described with reference to the accompanying drawings.

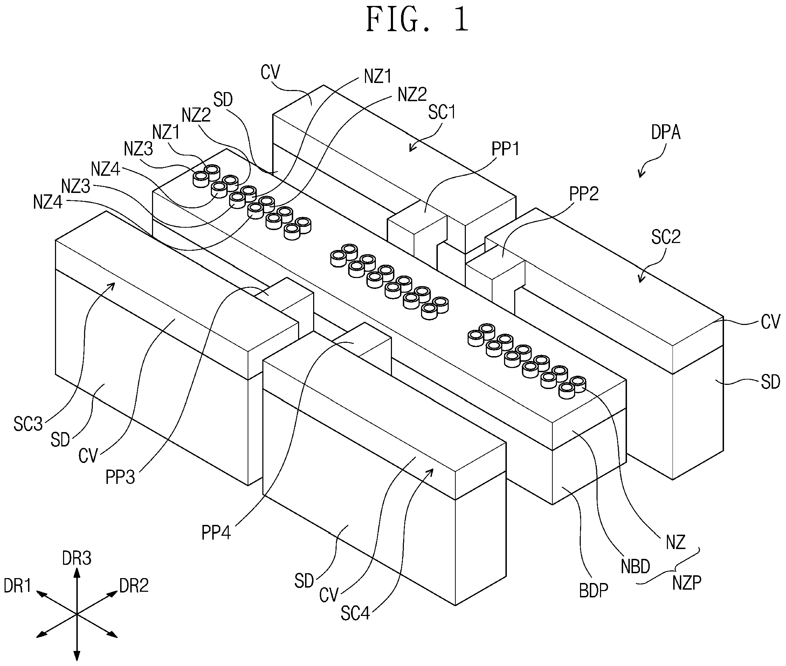

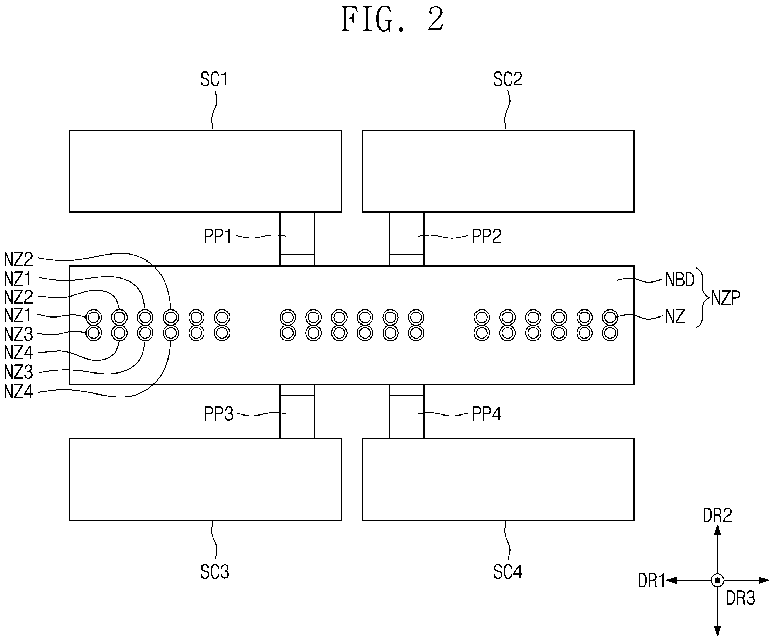

FIG. 1 is a schematic perspective view of an evaporation device according to an embodiment. FIG. 2 is a schematic plan view of the evaporation device illustrated in FIG. 1 as viewed from above.

Referring to FIGS. 1 and 2, the evaporation device DPA according to an embodiment may include a plurality of deposition sources SC1 to SC4, a body part BDP, a nozzle part NZP, and a plurality of pipes PP1 to PP4.

Different deposition materials may be accommodated in the deposition sources SC1 to SC4. The deposition materials may include hosts and dopants. The deposition sources SC1 to SC4 may include the first deposition source SC1, the second deposition source SC2, the third deposition source SC3, and the fourth deposition source SC4.

The first deposition source SC1 and the second deposition source SC2 may be arranged (or disposed) in a first direction DR1. The third deposition source SC3 and the fourth deposition source SC4 may be arranged in the first direction DR1. The third and fourth deposition sources SC3 and SC4 may be spaced apart from the first and second deposition sources SC1 and SC2 in a second direction DR2 intersecting the first direction DR1. The third deposition source SC3 may be spaced apart from the first deposition source SC1 in the second direction DR2. The fourth deposition source SC4 may be spaced apart from the second deposition source SC2 in the second direction DR2.

Each of the first, second, third, and fourth deposition sources SC1, SC2, SC3, and SC4 may include a body SD and a cover CV coupled or connected to an upper end of the body SD. Each of the first, second, third, and fourth deposition sources SC1, SC2, SC3, and SC4 may have a receiving space defined therein. The body SD and the cover CV may be coupled or connected with each other to define the receiving space in each of the first, second, third, and fourth deposition sources SC1, SC2, SC3, and SC4.

The different deposition materials may be accommodated in the first, second, third, and fourth deposition sources SC1, SC2, SC3, and SC4, respectively. For example, a first host may be accommodated in the first deposition source SC1, a first dopant may be accommodated in the second deposition source SC2, a second dopant may be accommodated in the third deposition source SC3, and a second host may be accommodated in the fourth deposition source SC4.

However, without being limited thereto, various deposition materials may be accommodated in the first, second, third, and fourth deposition sources SC1, SC2, SC3, and SC4. For example, one host and three dopants may be accommodated in the first, second, third, and fourth deposition sources SC1, SC2, SC3, and SC4, or three hosts and one dopant may be accommodated in the first, second, third, and fourth deposition sources SC1, SC2, SC3, and SC4.

Hereinafter, a direction intersecting a plane defined by the first and second directions DR1 and DR2 is defined as a third direction DR3. The third direction DR3 may be substantially perpendicular to the plane defined by the first and second directions DR1 and DR2. As used herein, the expression "when viewed from above the plane" may mean that it is viewed in the third direction DR3.

When viewed from above the plane, the body part BDP and the nozzle part NZP may be spaced apart from the first and second deposition sources SC1 and SC2 in the second direction DR2. When viewed from above the plane, the body part BDP and the nozzle part NZP may be spaced apart from the third and fourth deposition sources SC3 and SC4 in the second direction DR2. The body part BDP and the nozzle part NZP may be disposed between the first and second deposition sources SC1 and SC2 and the third and fourth deposition sources SC3 and SC4.

The nozzle part NZP may include a nozzle body part NBD disposed on the body part BDP and a plurality of nozzles NZ disposed on the nozzle body part NBD. The nozzle body part NBD may be connected to an upper end of the body part BDP. The nozzles NZ may protrude upward (for example, in the third direction DR3) from an upper end of the nozzle body part NBD. In an embodiment, the nozzles NZ may be separately manufactured and may be connected to the upper end of the nozzle body part NBD. However, without being limited thereto, the nozzles NZ may be integral with the nozzle body part NBD.

The nozzles NZ may include a plurality of first nozzles NZ1, a plurality of second nozzles NZ2, a plurality of third nozzles NZ3, and a plurality of fourth nozzles NZ4.

The first nozzles NZ1 and the second nozzles NZ2 may protrude upward from the upper end of the nozzle body part NBD. The first nozzles NZ1 and the second nozzles NZ2 may be adjacent to the first and second deposition sources SC1 and SC2. The first nozzles NZ1 and the second nozzles NZ2 may be arranged in the first direction DR1. The first nozzles NZ1 may alternate with the second nozzles NZ2 in the first direction DR1.

The third nozzles NZ3 and the fourth nozzles NZ4 may protrude upward from the upper end of the nozzle body part NBD. The third nozzles NZ3 and the fourth nozzles NZ4 may be adjacent to the third and fourth deposition sources SC3 and SC4. The third nozzles NZ3 and the fourth nozzles NZ4 may be arranged in the first direction DR1. The third nozzles NZ3 may alternate with the fourth nozzles NZ4 in the first direction DR1.

The third and fourth nozzles NZ3 and NZ4 may be adjacent to the first and second nozzles NZ1 and NZ2 in the second direction DR2, respectively. Specifically, the third nozzles NZ3 may be disposed adjacent to the first nozzles NZ1 in the second direction DR2, respectively. The fourth nozzles NZ4 may be disposed adjacent to the second nozzles NZ2 in the second direction DR2, respectively.

The third and fourth nozzles NZ3 and NZ4 may make direct contact with the first and second nozzles NZ1 and NZ2 in the second direction DR2, respectively. Specifically, the third nozzles NZ3 may make direct contact with the first nozzles NZ1 in the second direction DR2, respectively. The fourth nozzles NZ4 may make direct contact with the second nozzles NZ2 in the second direction DR2, respectively.

The pipes PP1 to PP4 may include the first pipe PP1 connected to the first deposition source SC1, the second pipe PP2 connected to the second deposition source SC2, the third pipe PP3 connected to the third deposition source SC3, and the fourth pipe PP4 connected to the fourth deposition source SC4.

The first pipe PP1 may be connected to a side surface of the first deposition source SC1 that faces the body part BDP and the nozzle body part NBD. The second pipe PP2 may be connected to a side surface of the second deposition source SC2 that faces the body part BDP and the nozzle body part NBD. The third pipe PP3 may be connected to a side surface of the third deposition source SC3 that faces the body part BDP and the nozzle body part NBD. The fourth pipe PP4 may be connected to a side surface of the fourth deposition source SC4 that faces the body part BDP and the nozzle body part NBD.

The first, second, third, and fourth pipes PP1, PP2, PP3, and PP4 may be connected to the body part BDP. The first, second, third, and fourth pipes PP1, PP2, PP3, and PP4 may extend below the body part BDP and may be connected to the body part BDP. This configuration will be described below in detail.

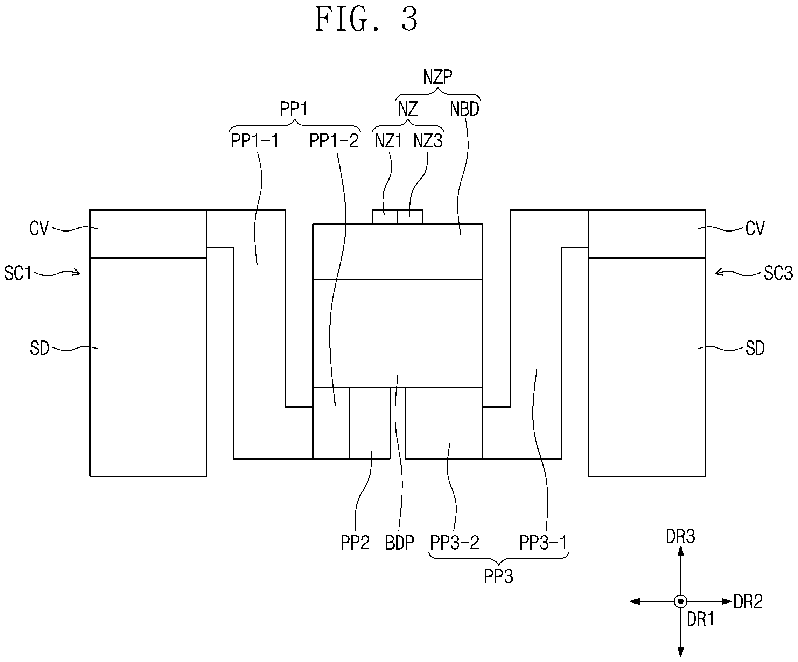

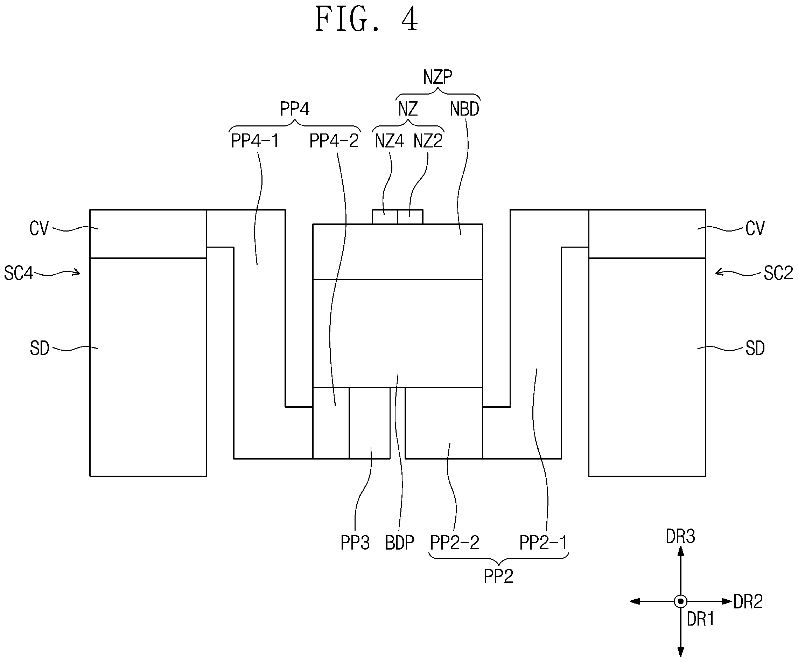

FIG. 3 is a side view of the evaporation device when the first and third deposition sources illustrated in FIG. 1 are viewed in the first direction. FIG. 4 is a side view of the evaporation device when the second and fourth deposition sources illustrated in FIG. 1 are viewed in the first direction.

Referring to FIGS. 3 and 4, the first pipe PP1 may be connected to the side surface of the first deposition source SC1. The first pipe PP1 may extend below the body part BDP and may be connected to a lower end of the body part BDP. The second pipe PP2 may be connected to the side surface of the second deposition source SC2. The second pipe PP2 may extend below the body part BDP and may be connected to the lower end of the body part BDP.

The third pipe PP3 may be connected to the side surface of the third deposition source SC3. The third pipe PP3 may extend below the body part BDP and may be connected to the lower end of the body part BDP. The fourth pipe PP4 may be connected to the side surface of the fourth deposition source SC4. The fourth pipe PP4 may extend below the body part BDP and may be connected to the lower end of the body part BDP.

The first pipe PP1 may include a first-first pipe PP1-1 connected to the side surface of the first deposition source SC1 and a first-second pipe PP1-2 connected to the lower end of the body part BDP. The first-first pipe PP1-1 may be connected to an upper portion (for example, the cover CV) of the side surface of the first deposition source SC1 and may extend downward. The first-second pipe PP1-2 may be connected to a lower portion of the first-first pipe PP1-1. The first-second pipe PP1-2 may be disposed below the body part BDP and may be connected to the lower end of the body part BDP.

The second pipe PP2 may include a second-first pipe PP2-1 connected to the side surface of the second deposition source SC2 and a second-second pipe PP2-2 connected to the lower end of the body part BDP. The second-first pipe PP2-1 may be connected to an upper portion (for example, the cover CV) of the side surface of the second deposition source SC2 and may extend downward. The second-second pipe PP2-2 may be connected to a lower portion of the second-first pipe PP2-1. The second-second pipe PP2-2 may be disposed below the body part BDP and may be connected to the lower end of the body part BDP.

The third pipe PP3 may include a third-first pipe PP3-1 connected to the side surface of the third deposition source SC3 and a third-second pipe PP3-2 connected to the lower end of the body part BDP. The third-first pipe PP3-1 may be connected to an upper portion (for example, the cover CV) of the side surface of the third deposition source SC3 and may extend downward. The third-second pipe PP3-2 may be connected to a lower portion of the third-first pipe PP3-1. The third-second pipe PP3-2 may be disposed below the body part BDP and may be connected to the lower end of the body part BDP.

The fourth pipe PP4 may include a fourth-first pipe PP4-1 connected to the side surface of the fourth deposition source SC4 and a fourth-second pipe PP4-2 connected to the lower end of the body part BDP. The fourth-first pipe PP4-1 may be connected to an upper portion (for example, the cover CV) of the side surface of the fourth deposition source SC4 and may extend downward. The fourth-second pipe PP4-2 may be connected to a lower portion of the fourth-first pipe PP4-1. The fourth-second pipe PP4-2 may be disposed below the body part BDP and may be connected to the lower end of the body part BDP.

The upper portions of the side surfaces of the first, second, third, and fourth deposition sources SC1, SC2, SC3, and SC4 may be defined by side surfaces of the covers CV of the first, second, third, and fourth deposition sources SC1, SC2, SC3, and SC4, respectively.

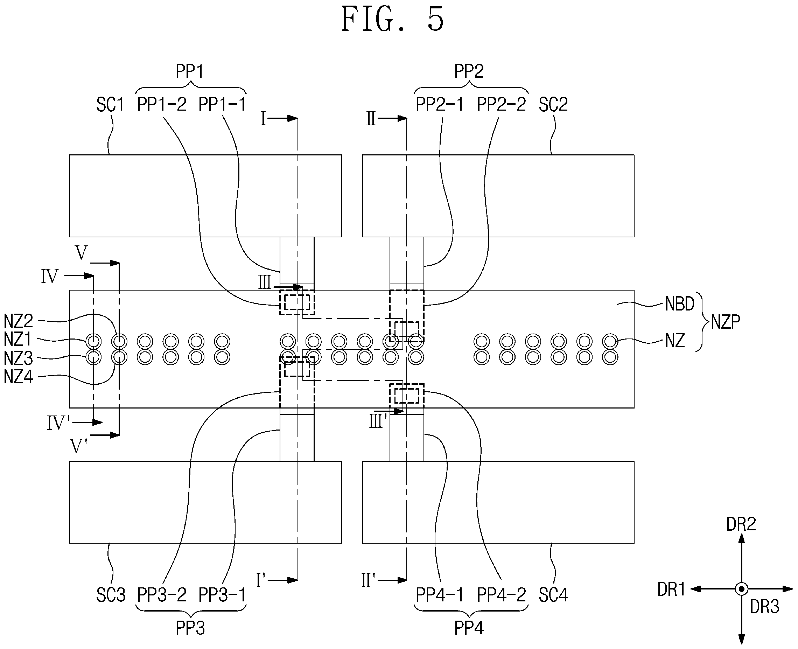

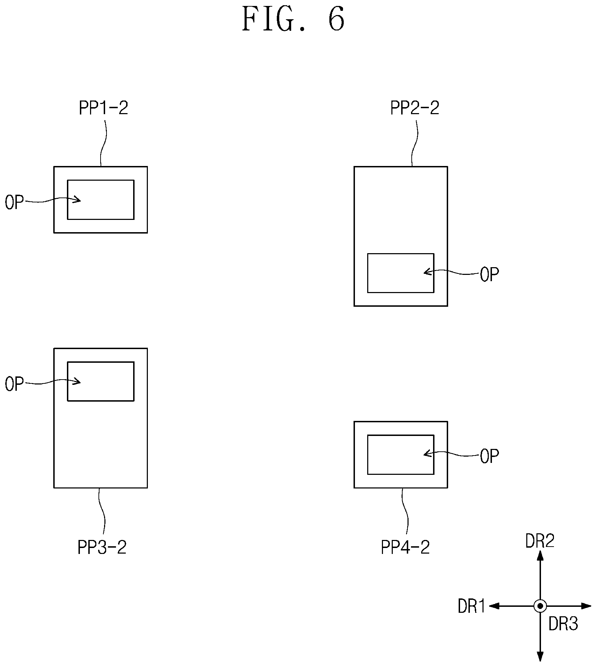

Hereinafter, a planar structure of the first-second, second-second, third-second, and fourth-second pipes PP1-2, PP2-2, PP3-2, and PP4-2 will be described in detail with reference to FIGS. 5 and 6.

FIG. 5 is a view in which the first-second pipe, the second-second pipe, the third-second pipe, and the fourth-second pipe illustrated in FIGS. 3 and 4 are illustrated on the schematic plan view of FIG. 2 by dotted lines. FIG. 6 is a schematic plan view separately illustrating the first-second pipe, the second-second pipe, the third-second pipe, and the fourth-second pipe illustrated in FIG. 5.

Referring to FIGS. 5 and 6, when viewed from above the plane, the first and second pipes PP1 and PP2 may be adjacent to the first and second deposition sources SC1 and SC2 in the second direction DR2, respectively. When viewed from above the plane, the third and fourth pipes PP3 and PP4 may be adjacent to the third and fourth deposition sources SC3 and SC4 in the second direction DR2, respectively.

When viewed from above the plane, the first pipe PP1 and the second pipe PP2 may be adjacent to each other in the first direction DR1. When viewed from above the plane, the third pipe PP3 and the fourth pipe PP4 may be adjacent to each other in the first direction DR1.

The first-second pipe PP1-2 and the second-second pipe PP2-2 may be arranged in the first direction DR1 and may be disposed to face each other in the first direction DR1. The third-second pipe PP3-2 and the fourth-second pipe PP4-2 may be arranged in the first direction DR1 and may be disposed to face each other in the first direction DR1.

When viewed from above the plane, the first-second pipe PP1-2 and the second-second pipe PP2-2 may have a quadrangular shape. In the second direction DR2, the length of the second-second pipe PP2-2 may be longer than the length of the first-second pipe PP1-2. It is to be understood that the shapes of the pipes are not limited to those disclosed herein and may also include shapes substantially the same as the shapes disclosed herein.

When viewed from above the plane, the third-second pipe PP3-2 and the fourth-second pipe PP4-2 may have a quadrangular shape. In the second direction DR2, the length of the third-second pipe PP3-2 may be longer than the length of the fourth-second pipe PP4-2.

The first-second pipe PP1-2 and the third-second pipe PP3-2 may be arranged in the second direction DR2 between the first deposition source SC1 and the third deposition source SC3. Depending on this structure, side surfaces of the first-second pipe PP1-2 and the third-second pipe PP3-2 may be illustrated in the side view of FIG. 3.

The second-second pipe PP2-2 and the fourth-second pipe PP4-2 may be arranged in the second direction DR2 between the second deposition source SC2 and the fourth deposition source SC4. Depending on this structure, side surfaces of the second-second pipe PP2-2 and the fourth-second pipe PP4-2 may be illustrated in the side view of FIG. 4.

Openings OP may be defined in the first-second, second-second, third-second, and fourth-second pipes PP1-2, PP2-2, PP3-2, and PP4-2, respectively. The openings OP may be defined to face toward the body part BDP. The openings OP may have a quadrangular shape.

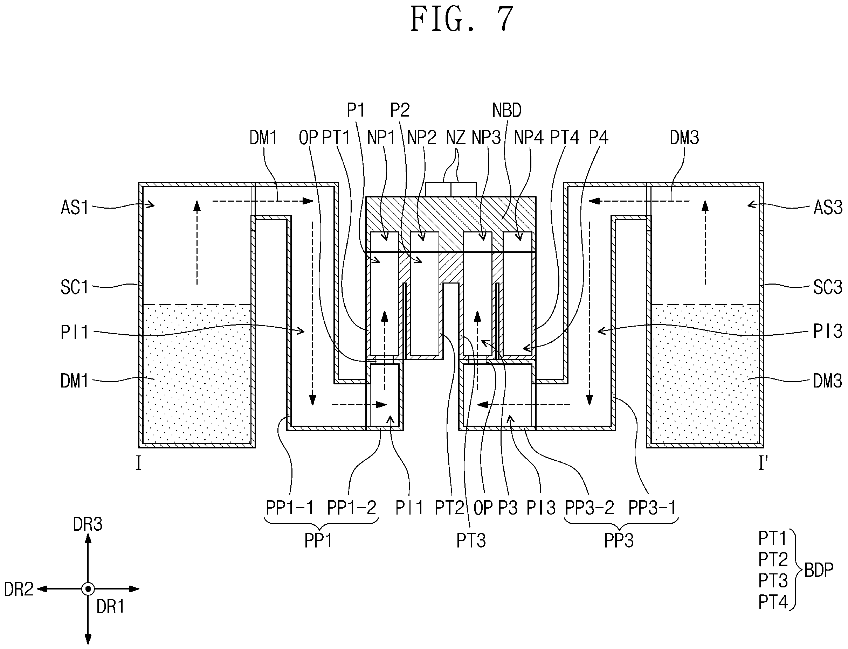

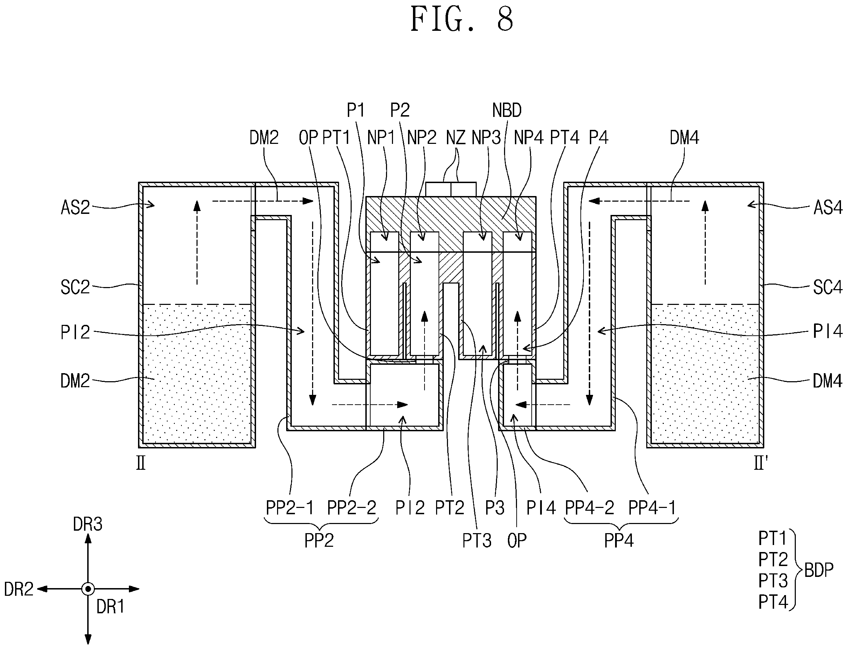

FIG. 7 is a sectional view taken along line I-I' illustrated in FIG. 5. FIG. 8 is a sectional view taken along line II-II' illustrated in FIG. 5.

Referring to FIGS. 7 and 8, the body part BDP may include a first portion PT1, a second portion PT2, a third portion PT3, and a fourth portion PT4 arranged in the second direction DR2. The nozzle body part NBD may be disposed on the first, second, third, and fourth portions PT1, PT2, PT3, and PT4.

The first-second pipe PP1-2 may be disposed below the first portion PT1 and may be connected to the first portion PT1. The second-second pipe PP2-2 may be disposed below the first and second portions PT1 and PT2 and may be connected to the first and second portions PT1 and PT2.

The third-second pipe PP3-2 may be disposed below the third and fourth portions PT3 and PT4 and may be connected to the third and fourth portions PT3 and PT4. The fourth-second pipe PP4-2 may be disposed below the fourth portion PT4 and may be connected to the fourth portion PT4.

A first deposition material DM1 may be accommodated in a first receiving space AS1 defined in the first deposition source SC1. A second deposition material DM2 may be accommodated in a second receiving space AS2 defined in the second deposition source SC2. A third deposition material DM3 may be accommodated in a third receiving space AS3 defined in the third deposition source SC3. A fourth deposition material DM4 may be accommodated in a fourth receiving space AS4 defined in the fourth deposition source SC4.

The first deposition material DM1 may include the first host, and the second deposition material DM2 may include the first dopant. The third deposition material DM3 may include the second dopant, and the fourth deposition material DM4 may include the second host.

Although not illustrated, the first, second, third, and fourth deposition sources SC1, SC2, SC3, and SC4 may include heat sources for heating and vaporizing the first, second, third, and fourth deposition materials DM1, DM2, DM3, and DM4.

A first pipe passage PI1 may be defined in the first pipe PP1, and a second pipe passage PI2 may be defined in the second pipe PP2. A third pipe passage PI3 may be defined in the third pipe PP3, and a fourth pipe passage PI4 may be defined in the fourth pipe PP4.

The first pipe passage PI1 may be defined to be continuous with the first receiving space AS1. The second pipe passage PI2 may be defined to be continuous with the second receiving space AS2. The third pipe passage PI3 may be defined to be continuous with the third receiving space AS3. The fourth pipe passage PI4 may be defined to be continuous with the fourth receiving space AS4.

A first passage P1 may be defined in the first portion PT1, and a second passage PI2 may be defined in the second portion PT2. A third passage P3 may be defined in the third portion PT3, and a fourth passage P4 may be defined in the fourth portion PT4. The first, second, third, and fourth passages P1, P2, P3, and P4 may extend in the third direction DR3.

The first passage P1 may be defined to be continuous with the first pipe passage PI1. The second passage P2 may be defined to be continuous with the second pipe passage PI2. The third passage P3 may be defined to be continuous with the third pipe passage PI3. The fourth passage P4 may be defined to be continuous with the fourth pipe passage PI4.

The openings OP illustrated in FIG. 6 may be defined in upper portions of the first-second, second-second, third-second, and fourth-second pipes PP1-2, PP2-2, PP3-2, and PP4-2. The first to fourth passages P1 to P4 may be defined to be continuous with the first to fourth pipe passages PI1 to PI4 through the openings OP.

A first nozzle passage NP1, a second nozzle passage NP2, a third nozzle passage NP3, and a fourth nozzle passage NP4 may be defined in the nozzle body part NBD. The first nozzle passage NP1 may be defined to be continuous with the first passage P1, and the second nozzle passage NP2 may be defined to be continuous with the second passage P2. The third nozzle passage NP3 may be defined to be continuous with the third passage P3, and the fourth nozzle passage NP4 may be defined to be continuous with the fourth passage P4.

The first deposition material DM1 may be vaporized in the first deposition source SC1, and the vaporized first deposition material DM1 may move through the first pipe passage PI1, the first passage P1, and the first nozzle passage NP1. The second deposition material DM2 may be vaporized in the second deposition source SC2, and the vaporized second deposition material DM2 may move through the second pipe passage PI2, the second passage P2, and the second nozzle passage NP2.

The third deposition material DM3 may be vaporized in the third deposition source SC3, and the vaporized third deposition material DM3 may move through the third pipe passage PI3, the third passage P3, and the third nozzle passage NP3. The fourth deposition material DM4 may be vaporized in the fourth deposition source SC4, and the vaporized fourth deposition material DM4 may move through the fourth pipe passage PI4, the fourth passage P4, and the fourth nozzle passage NP4.

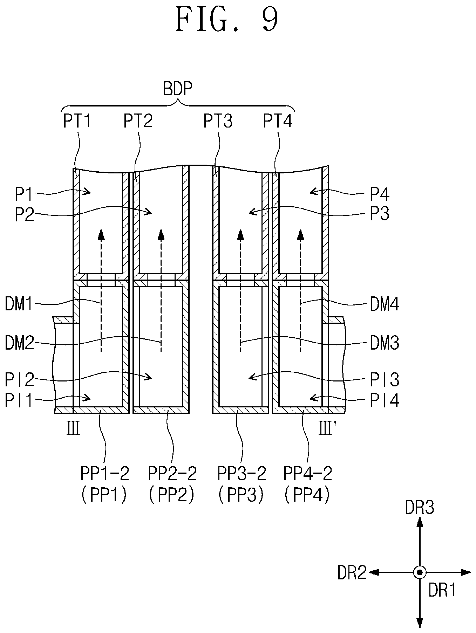

FIG. 9 is a sectional view taken along line III-III' illustrated in FIG. 5.

For convenience of description, the nozzle part NZP is omitted in FIG. 9.

Referring to FIG. 9, the first-second pipe PP1-2 of the first pipe PP1 may be disposed below the first portion PT1 and may be connected to a lower end of the first portion PT1. The second-second pipe PP2-2 of the second pipe PP2 may be disposed below the second portion PT2 and may be connected to a lower end of the second portion PT2.

The third-second pipe PP3-2 of the third pipe PP3 may be disposed below the third portion PT3 and may be connected to a lower end of the third portion PT3. The fourth-second pipe PP4-2 of the fourth pipe PP4 may be disposed below the fourth portion PT4 and may be connected to a lower end of the fourth portion PT4.

The first deposition material DM1 may move through the first pipe passage PI1 defined in the first-second pipe PP1-2 and the first passage P1 defined in the first portion PT1. The second deposition material DM2 may move through the second pipe passage PI2 defined in the second-second pipe PP2-2 and the second passage P2 defined in the second portion PT2.

The third deposition material DM3 may move through the third pipe passage PI3 defined in the third-second pipe PP3-2 and the third passage P3 defined in the third portion PT3. The fourth deposition material DM4 may move through the fourth pipe passage PI4 defined in the fourth-second pipe PP4-2 and the fourth passage P4 defined in the fourth portion PT4.

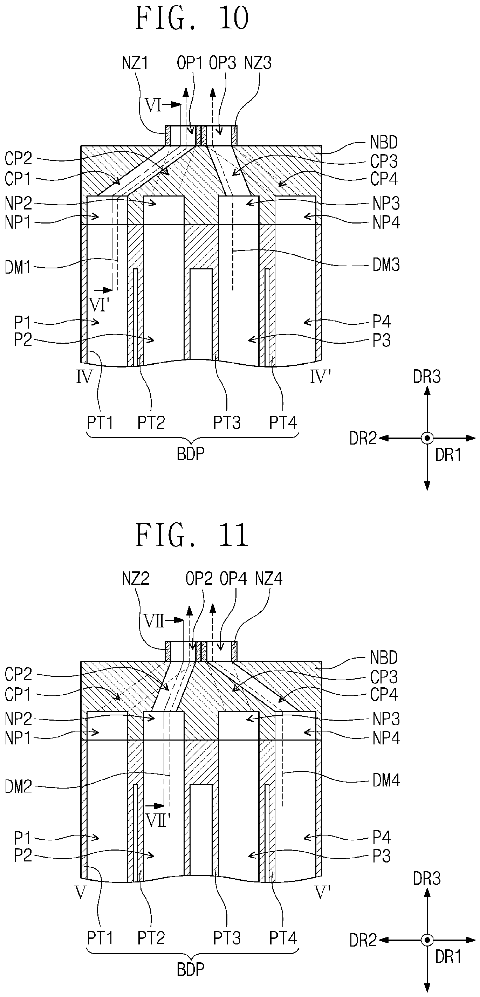

FIG. 10 is a sectional view taken along line IV-IV' illustrated in FIG. 5. FIG. 11 is a sectional view taken along line V-V' illustrated in FIG. 5.

For convenience of description, a lower portion of the body part BDP is omitted in FIGS. 10 and 11.

Referring to FIGS. 10 and 11, a first opening OP1 may be defined in the first nozzle NZ1. The first opening OP1 may be defined to be continuous with the first nozzle passage NP1. For example, a first connecting passage CP1 that is defined to be continuous with the first nozzle passage NP1 and that extends toward the first nozzle NZ1 may be defined in the nozzle body part NBD. The first opening OP1 may be defined to be continuous with the first connecting passage CP1. For example, the first opening OP1 may be defined to be continuous with the first nozzle passage NP1 through the first connecting passage CP1.

A second opening OP2 may be defined in the second nozzle NZ2. The second opening OP2 may be defined to be continuous with the second nozzle passage NP2. For example, a second connecting passage CP2 that is defined to be continuous with the second nozzle passage NP2 and that extends toward the second nozzle NZ2 may be defined in the nozzle body part NBD. The second opening OP2 may be defined to be continuous with the second connecting passage CP2. For example, the second opening OP2 may be defined to be continuous with the second nozzle passage NP2 through the second connecting passage CP2.

A third opening OP3 may be defined in the third nozzle NZ3. The third opening OP3 may be defined to be continuous with the third nozzle passage NP3. For example, a third connecting passage CP3 that is defined to be continuous with the third nozzle passage NP3 and that extends toward the third nozzle NZ3 may be defined in the nozzle body part NBD. The third opening OP3 may be defined to be continuous with the third connecting passage CP3. For example, the third opening OP3 may be defined to be continuous with the third nozzle passage NP3 through the third connecting passage CP3.

A fourth opening OP4 may be defined in the fourth nozzle NZ4. The fourth opening OP4 may be defined to be continuous with the fourth nozzle passage NP4. For example, a fourth connecting passage CP4 that is defined to be continuous with the fourth nozzle passage NP4 and that extends toward the fourth nozzle NZ4 may be defined in the nozzle body part NBD. The fourth opening OP4 may be defined to be continuous with the fourth connecting passage CP4. For example, the fourth opening OP4 may be defined to be continuous with the fourth nozzle passage NP4 through the fourth connecting passage CP4.

In FIG. 10, the second and fourth connecting passages CP2 and CP4 are illustrated by dotted lines, and in FIG. 11, the first and third connecting passages CP1 and CP3 are illustrated by dotted lines.

The first deposition material DM1 may be dispensed through the first nozzle NZ1. Specifically, the vaporized first deposition material DM1 may be dispensed upward through the first nozzle passage NP1, the first connecting passage CP1, and the first opening OP1.

The second deposition material DM2 may be dispensed through the second nozzle NZ2. Specifically, the vaporized second deposition material DM2 may be dispensed upward through the second nozzle passage NP2, the second connecting passage CP2, and the second opening OP2.

The third deposition material DM3 may be dispensed through the third nozzle NZ3. Specifically, the vaporized third deposition material DM3 may be dispensed upward through the third nozzle passage NP3, the third connecting passage CP3, and the third opening OP3.

The fourth deposition material DM4 may be dispensed through the fourth nozzle NZ4. Specifically, the vaporized fourth deposition material DM4 may be dispensed upward through the fourth nozzle passage NP4, the fourth connecting passage CP4, and the fourth opening OP4.

The first to fourth deposition materials DM1 to DM4 may be provided to the first to fourth nozzles NZ1 to NZ4 through the first to fourth nozzle passages NP1 to NP4 and the first to fourth connecting passages CP1 to CP4 defined in the single nozzle body part NBD.

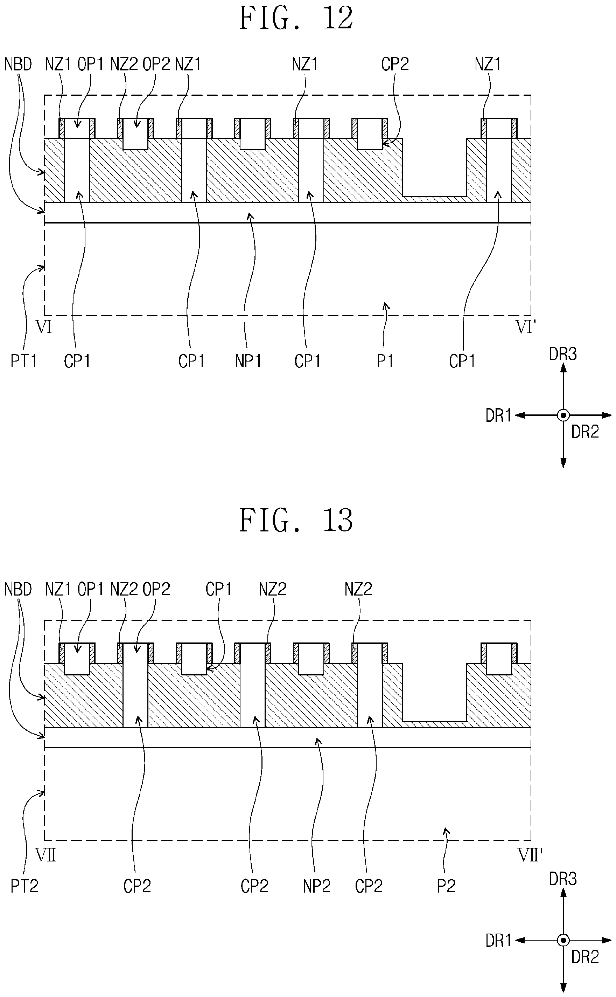

FIG. 12 is a sectional view taken along line VI-VI' illustrated in FIG. 10. FIG. 13 is a sectional view taken along line VII-VII' illustrated in FIG. 11.

FIGS. 12 and 13 illustrate sections taken along line VI-VI' and line VII-VII' in the first direction DR1, where FIGS. 12 and 13 are sectional views viewed in the second direction DR2. Substantially, FIG. 12 is a sectional view of the first openings OP1 and the first connecting passages CP1, and FIG. 13 is a sectional view of the second openings OP2 and the second connecting passages CP2. Sections of seven nozzles NZ among the nozzles NZ illustrated in FIG. 1 are illustrated in FIGS. 12 and 13.

Referring to FIG. 12, the plurality of first connecting passages CP1 may be defined in the nozzle body part NBD. The first connecting passages CP1 may be defined to be continuous with the first nozzle passage NP1 and may extend in the third direction DR3. Portions of the second connecting passages CP2 are illustrated in the sectional view of FIG. 12.

The first connecting passages CP1 may extend toward the first nozzles NZ1, respectively. The first openings OP1 defined in the first nozzles NZ1 may be defined to be continuous with the first connecting passages CP1, respectively. For example, the first openings OP1 and the first connecting passages CP1 may be formed as integrated continuous spaces.

Referring to FIG. 13, the plurality of second connecting passages CP2 may be defined in the nozzle body part NBD. The second connecting passages CP2 may be defined to be continuous with the second nozzle passage NP2 and may extend in the third direction DR3. Portions of the first connecting passages CP1 are illustrated in the sectional view of FIG. 13.

The second connecting passages CP2 may extend toward the second nozzles NZ2, respectively. The second openings OP2 defined in the second nozzles NZ2 may be defined to be continuous with the second connecting passages CP2, respectively. For example, the second openings OP2 and the second connecting passages CP2 may be formed as integrated continuous spaces.

Referring to FIGS. 12 and 13, since the first nozzles NZ1 alternate with the second nozzles NZ2, the first openings OP1 may alternate with the second openings OP2, and the first connecting passages CP1 may alternate with the second connecting passages CP2.

Although not illustrated, the sectional configuration of the third openings OP3 and the third connecting passages CP3 may be substantially the same as the sectional configuration of the first openings OP1 and the first connecting passages CP1. Although not illustrated, the sectional configuration of the fourth openings OP4 and the fourth connecting passages CP4 may be substantially the same as the sectional configuration of the second openings OP2 and the second connecting passages CP2.

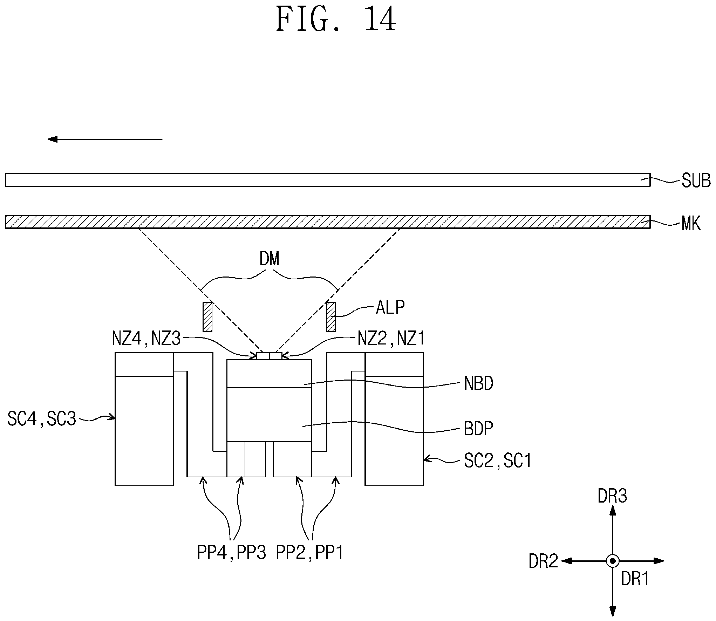

FIG. 14 is a view for explaining a deposition process using the evaporation device illustrated in FIG. 1.

In FIG. 14, the side surface of the evaporation device DPA illustrated in FIG. 4 is illustrated in a reduced scale. Accordingly, the side surface of the evaporation device DPA is illustrated in the state in which the second and fourth nozzles NZ2 and NZ4 and the second and fourth deposition sources SC2 and SC4 are viewed, and for convenience of description, the reference numerals of the first and third nozzles NZ1 and NZ3 and the first and third deposition sources SC1 and SC3 are illustrated together in FIG. 14.

Referring to FIG. 14, a substrate SUB may be disposed over the evaporation device DPA. A mask MK may be disposed on the lower surface of the substrate SUB. Although not illustrated, a plurality of openings for passing deposition materials may be defined in the mask MK. An angle limiting plate ALP may be disposed between the mask MK and the evaporation device DPA.

Referring to FIGS. 1 and 14, vaporized deposition materials DM may be dispensed upward from the first to fourth deposition sources SC1 to SC4 through the nozzles NZ. The dispensing angle of the deposition materials DM may be limited by the angle limiting plate ALP.

The deposition materials DM may include the above-described first to fourth deposition materials DM1 to DM4. As described above, the first to fourth deposition materials DM1 to DM4 may include hosts and dopants.

The deposition materials DM may be provided on the substrate SUB through the openings of the mask MK and may be deposited on the substrate SUB. The deposition materials DM may be provided on the substrate SUB while the substrate SUB and the mask MK move in the second direction DR2. However, without being limited thereto, the deposition materials DM may be provided on the substrate SUB while the evaporation device DPA moves in the second direction DR2.

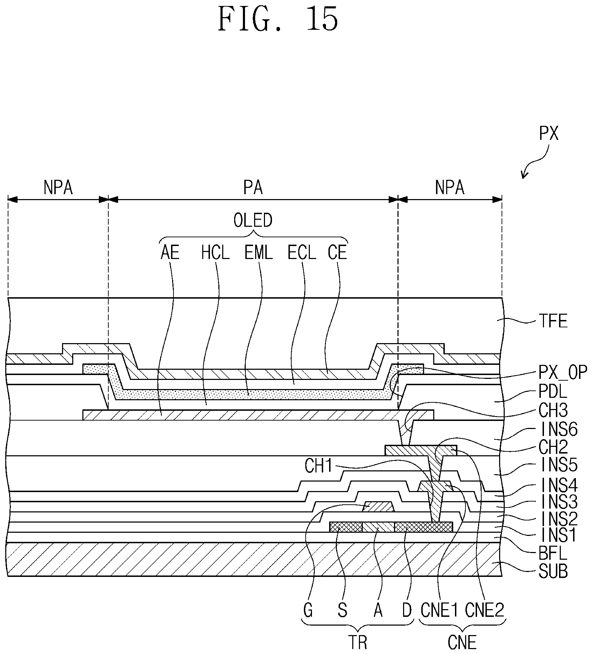

FIG. 15 is a view illustrating a section of a pixel including an emissive layer formed by the evaporation device illustrated in FIG. 1.

Referring to FIG. 15, the pixel PX may include a transistor TR and a light emitting element OLED connected to the transistor TR. Although one pixel PX is illustrated as an example, a plurality of pixels PX may be substantially disposed on a substrate SUB.

The light emitting element OLED may include a first electrode AE, a second electrode CE, a hole control layer HCL, an electron control layer ECL, and an emissive layer EML. The first electrode AE may be an anode electrode, and the second electrode CE may be a cathode electrode.

The transistor TR and the light emitting element OLED may be disposed on the substrate SUB. A flat region of the substrate SUB may be divided into an emissive part PA and a non-emissive part NPA around the emissive part PA. The light emitting element OLED may be disposed on the emissive part PA.

The substrate SUB may include a glass substrate or a flexible plastic substrate. A buffer layer BFL may be disposed on the substrate SUB. The buffer layer BFL may be an inorganic layer.

A semiconductor pattern S, A, and D may be disposed on the buffer layer BFL. The semiconductor layers S, A, and D may include poly silicon. However, without being limited thereto, the semiconductor pattern S, A, and D may include amorphous silicon or metal oxide.

The semiconductor pattern S, A, and D may be doped with an N-type dopant or a P-type dopant. The semiconductor pattern S, A, and D may include a heavily doped region and a lightly doped region. The heavily doped region may have a higher conductivity than the lightly doped region and may substantially serve as a source electrode and a drain electrode of the transistor TR. The lightly doped region may substantially correspond to an active (or, channel) region of the transistor TR.

The source S, the active region A, and the drain D of the transistor TR may be formed from the semiconductor pattern S, A, and D. A first insulating layer INS1 may be disposed on the semiconductor pattern S, A, and D. A gate G of the transistor TR may be disposed on the first insulating layer INS1. A second insulating layer INS2 may be disposed on the gate G. A third insulating layer INS3 may be disposed on the second insulating layer INS2.

A connecting electrode CNE may be disposed between the transistor TR and the light emitting element OLED and may connect the transistor TR and the light emitting element OLED. The connecting electrode CNE may include a first connecting electrode CNE1 and a second connecting electrode CNE2.

The first connecting electrode CNE1 may be disposed on the third insulating layer INS3 and may be connected to the drain D through a first contact hole CH1 defined in the first to third insulating layers INS1 to INS3. A fourth insulating layer INS4 may be disposed on the first connecting electrode CNE1. A fifth insulating layer INS5 may be disposed on the fourth insulating layer INS4.

The second connecting electrode CNE2 may be disposed on the fifth insulating layer INS5. The second connecting electrode CNE2 may be connected to the first connecting electrode CNE1 through a second contact hole CH2 defined in the fifth insulating layer INS5. A sixth insulating layer INS6 may be disposed on the second connecting electrode CNE2. The first to sixth insulating layers INS1 to INS6 may be inorganic layers or organic layers.

The first electrode AE may be disposed on the sixth insulating layer INS6. The first electrode AE may be connected to the second connecting electrode CNE2 through a third contact hole CH3 defined in the sixth insulating layer INS6. A pixel defining film PDL exposing a selectable portion of the first electrode AE may be disposed on the first electrode AE and the sixth insulating layer INS6. An opening PX-OP for exposing the selectable portion of the first electrode AE may be defined in the pixel defining layer PDL.

The hole control layer HCL may be disposed on the first electrode AE and the pixel defining layer PDL. The hole control layer HCL may be commonly disposed on the emissive part PA and the non-emissive part NPA. The hole control layer HCL may include a hole transport layer and a hole injection layer.

The emissive layer EML may be disposed on the hole control layer HCL. The emissive layer EML may be disposed in a region corresponding to the opening PX_OP. The emissive layer EML may include an organic material and/or an inorganic material. The emissive layer EML may generate one of red light, green light, and blue light.

The electron control layer ECL may be disposed on the emissive layer EML and the hole control layer HCL. The electron control layer ECL may be commonly disposed on the emissive part PA and the non-emissive part NPA. The electron control layer ECL may include an electron transport layer and an electron injection layer.

The second electrode CE may be disposed on the electron control layer ECL. The second electrode CE may be commonly disposed in the pixels PX.

A thin film encapsulation layer TFE may be disposed on the light emitting element OLED. The thin film encapsulation layer TFE may be disposed on the second electrode CE and may cover the pixel PX. The thin film encapsulation layer TFE may include at least two inorganic layers and an organic layer between the inorganic layers. The inorganic layers may protect the pixel PX from moisture/oxygen. The organic layer may protect the pixel PX from foreign matter such as dust particles.

A first voltage may be applied to the first electrode AE through the transistor TR, and a second voltage having a lower level than the first voltage may be applied to the second electrode CE. Holes and electrons injected into the emissive layer EML may be combined to form excitons, and as the excitons transition to a ground state, the light emitting element OLED may emit light.

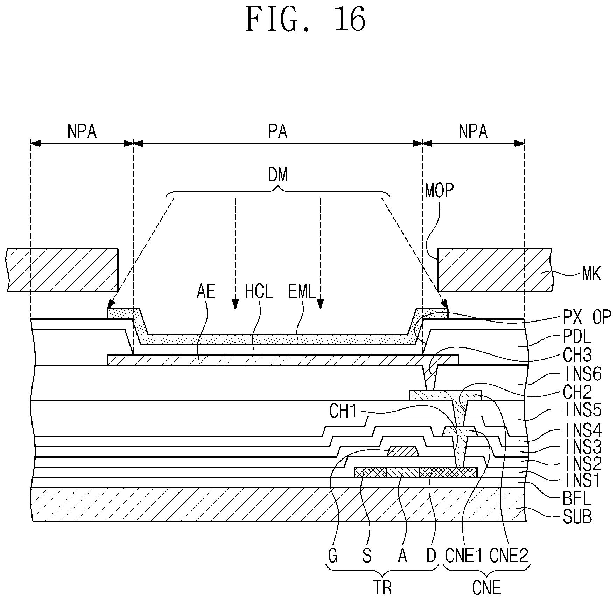

FIG. 16 is a view for explaining a process of forming the emissive layer using the evaporation device illustrated in FIG. 14.

Referring to FIG. 16, a mask MK may be disposed over the substrate SUB. For convenience of description, the emissive layer EML is illustrated as facing upward, and the mask MK is illustrated as being disposed over the emissive layer EML. However, the structure illustrated in FIG. 16 may substantially correspond to an inverted state of FIG. 14 in a deposition process. For example, the emissive layer EML may face downward, the mask MK may be disposed under or below the emissive layer EML, and the evaporation device DPA may be disposed under or below the mask MK.

The hole control layer HCL may be disposed on the first electrode AE, and the mask MK may be used to form the emissive layer EML on the hole control layer HCL. A deposition material DM may be provided on the hole control layer HCL through an opening MOP defined in the mask MK. The emissive layer EML may be formed by the deposition material DM.

Although one emissive layer EML is formed on the substrate SUB, a plurality of emissive layers EML may be formed on the substrate SUB.

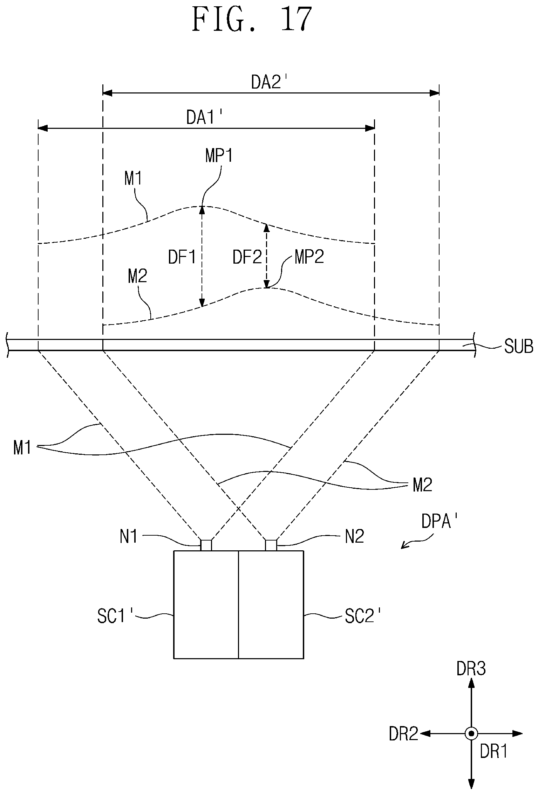

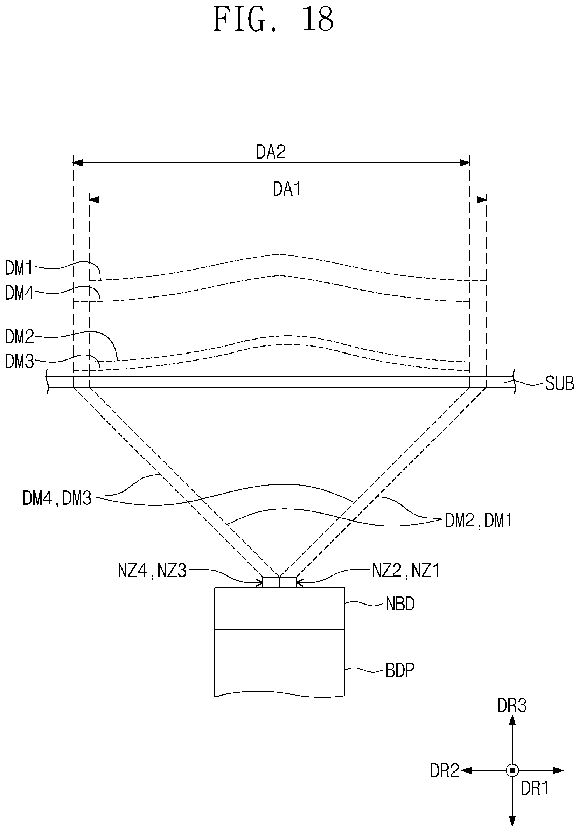

FIG. 17 illustrates deposition materials dispensed onto a substrate from an evaporation device having a different configuration from the evaporation device illustrated in FIG. 1 and dotted graphs depicting the distributions of the deposition materials. FIG. 18 illustrates deposition materials dispensed onto a substrate from the nozzles of the evaporation device illustrated in FIG. 1 and dotted graphs depicting the distributions of the deposition materials.

In FIGS. 17 and 18, for convenience of description, the dotted graphs depicting the distributions of the deposition materials M1, M2, and DM1 to DM4 are illustrated above the substrates SUB on which the deposition materials M1, M2, and DM1 to DM4 are provided. The dotted graphs may substantially represent the amounts of the deposition materials M1, M2, and DM1 to DM4 dispensed toward the substrates SUB. In FIGS. 17 and 18, masks MK are omitted. Furthermore, FIG. 18 is a side view corresponding to FIG. 14, and for convenience of description, the first to fourth deposition sources SC1 to SC4 and the first to fourth pipes PP1 to PP4 are omitted.

Referring to FIG. 17, the evaporation device DPA' may include a first deposition source SC1', a first nozzle N1 disposed on the first deposition source SC1', a second deposition source SC2' arranged in the second direction DR2 together with the first deposition source SC1', and a second nozzle N2 disposed on the second deposition source SC2'.

A first deposition material M1 may be accommodated in the first deposition source SC1', and a second deposition material M2 may be accommodated in the second deposition source SC2'. For example, the first deposition material M1 may be a host, and the second deposition material M2 may be a dopant.

The first deposition material M1 may be vaporized in the first deposition source SC1' and may be dispensed toward the substrate SUB through the first nozzle N1. The region of the substrate SUB on which the first deposition material M1 is provided may be defined as a first deposition region DA1'. The amount of the first deposition material M1 may be gradually increased toward the center of the first deposition region DA1' and may be gradually decreased toward the periphery of the first deposition region DA1'.

The second deposition material M2 may be vaporized in the second deposition source SC2' and may be dispensed toward the substrate SUB through the second nozzle N2. The region of the substrate SUB on which the second deposition material M2 is provided may be defined as a second deposition region DA2'. The amount of the second deposition material M2 may be gradually increased toward the center of the second deposition region DA2' and may be gradually decreased toward the periphery of the second deposition region DA2'.

The first deposition material M1 and the second deposition material M2 may be provided on the substrate SUB at a selectable ratio. For example, the first deposition material M1 and the second deposition material M2 may be provided on the substrate SUB at a ratio of 8:2. The amount of the first deposition material M1 provided on the substrate SUB may be greater than the amount of the second deposition material M2 provided on the substrate SUB. Accordingly, in FIG. 17, the distribution graph of the first deposition material M1 is illustrated above the distribution graph of the second deposition material M2.

In case that the first nozzle N1 and the second nozzle N2 are spaced apart from each other, the first deposition material M1 and the second deposition material M2 may not be provided on the substrate SUB at the selectable ratio. For example, the ratio between the first deposition material M1 and the second deposition material M2 at the first highest point MP1 where the largest amount of the first deposition material M1 is provided may be different from the ratio between the first deposition material M1 and the second deposition material M2 at the second highest point MP2 where the largest amount of the second deposition material M2 is provided.

The difference DF1 between the first deposition material M1 and the second deposition material M2 at the first highest point MP1 may be greater than the difference DF2 between the first deposition material M1 and the second deposition material M2 at the second highest point MP2. For example, the ratio of the first deposition material M1 to the second deposition material M2 may be further increased at the first highest point MP1 and may be decreased at the second highest point MP2. For example, the first deposition material M1 and the second deposition material M2 may not be provided on the substrate SUB at the selectable ratio.

The difference between the distribution graph of the first deposition material M1 and the distribution graph of the second deposition material M2 has to be constant so that the first deposition material M1 and the second deposition material M2 are provided on the substrate SUB at the selectable ratio. However, since the first nozzle N1 and the second nozzle N2 are spaced apart from each other so that the distribution graph of the first deposition material M1 does not match the distribution graph of the second deposition material M2, the first deposition material M1 and the second deposition material M2 may not be provided on the substrate SUB at the selectable ratio.

In this case, the mixing ratio between the first and second deposition materials M1 and M2 of emissive layers EML formed on the substrate SUB may not be constant. Accordingly, the emissive layers EML may have different lifetimes, and therefore the reliability of pixels PX may be lowered.

Hereinafter, in FIG. 18, a dispensing operation of the first nozzle NZ1 and a dispensing operation of the second nozzle NZ2 will be described together because the first and second nozzles NZ1 and NZ2 are arranged in the same row in the first direction DR1. Furthermore, in FIG. 18, a dispensing operation of the third nozzle NZ3 and a dispensing operation of the fourth nozzle NZ4 will be described together because the third and fourth nozzles NZ3 and NZ4 are arranged in the same row in the first direction DR1.

Referring to FIGS. 1 and 18, the first deposition material DM1 may be dispensed onto the substrate SUB through the first nozzle NZ1, and the third deposition material DM3 may be dispensed onto the substrate SUB through the third nozzle NZ3. The second deposition material DM2 may be dispensed onto the substrate SUB through the second nozzle NZ2 disposed in the same row as the first nozzle NZ1, and the fourth deposition material DM4 may be dispensed onto the substrate SUB through the fourth nozzle NZ4 disposed in the same row as the third nozzle NZ3.

The first, second, third, and fourth deposition materials DM1, DM2, DM3, and DM4 may be provided on the substrate SUB at a selectable ratio. The amounts by which the first and fourth deposition materials DM1 and DM4 including the hosts are provided on the substrate SUB may be greater than the amounts by which the second and third deposition materials DM2 and DM3 including the dopants are provided on the substrate SUB. Accordingly, in FIG. 18, the distribution graphs of the first and fourth deposition materials DM1 and DM4 are illustrated above the distribution graphs of the second and third deposition materials DM2 and DM3.

For example, the amount of the first deposition material DM1 provided on the substrate SUB may be greater than the amount of the fourth deposition material DM4 provided on the substrate SUB. Accordingly, the distribution graph of the first deposition material DM1 is illustrated above the distribution graph of the fourth deposition material DM4. Furthermore, the amount of the second deposition material DM2 provided on the substrate SUB may be greater than the amount of the third deposition material DM3 provided on the substrate SUB. Accordingly, the distribution graph of the second deposition material DM2 is illustrated above the distribution graph of the third deposition material DM3.

The region of the substrate SUB on which the first and second deposition materials DM1 and DM2 are provided may be defined as a first deposition region DA1. The region of the substrate SUB on which the third and fourth deposition materials DM3 and DM4 are provided may be defined as a second deposition region DA2.

The amounts of the first and second deposition materials DM1 and DM2 may be gradually increased toward the center of the first deposition region DA1, and the amounts of the first and second deposition materials DM1 and DM2 may be gradually decreased toward the periphery of the first deposition region DA1. The amounts of the third and fourth deposition materials DM3 and DM4 may be gradually increased toward the center of the second deposition region DA2, and the amounts of the third and fourth deposition materials DM3 and DM4 may be gradually decreased toward the periphery of the second deposition region DA2.

The first and second deposition materials DM1 and DM2 may be provided on the same first deposition region DA1 because the first and second nozzles NZ1 and NZ2 are disposed in the same row. Accordingly, the difference between the first deposition material DM1 and the second deposition material DM2 may be constant. For example, the first deposition material DM1 and the second deposition material DM2 may be provided on the substrate SUB at a selectable ratio.

The third and fourth deposition materials DM3 and DM4 may be provided on the same second deposition region DA2 because the third and fourth nozzles NZ3 and NZ4 are disposed in the same row. Accordingly, the difference between the third deposition material DM3 and the fourth deposition material DM4 may be constant. For example, the third deposition material DM3 and the fourth deposition material DM4 may be provided on the substrate SUB at a selectable ratio.

While the first nozzle N1 and the second nozzle N2 in FIG. 17 are spaced apart from each other in the second direction DR2, the first nozzle NZ1 and the third nozzle NZ3 in FIG. 18 may be brought into close contact with each other in the second direction DR2. Furthermore, in FIG. 18, the second nozzle NZ2 and the fourth nozzle NZ4 may be brought into close contact with each other in the second direction DR2. Accordingly, the gap between the first nozzle NZ1 and the third nozzle NZ3 may be minimized.

The difference between the first deposition region DA1 and the second deposition region DA2 may be smaller than the difference between the first deposition region DA1' and the second deposition region DA2' illustrated in FIG. 17. For example, the difference between the first deposition region DA1 and the second deposition region DA2 may be minimized.

In this case, the difference between the distribution graph of the first deposition material DM1 and the distribution graph of the third deposition material DM3 may be constant in case that compared to the difference between the distribution graph of the first deposition material M1 and the distribution graph of the second deposition material M2 illustrated in FIG. 17.

The distribution graph of the first deposition material DM1 and the distribution graph of the third deposition material DM3 may similarly match each other because the gap between the first nozzle NZ1 and the third nozzle NZ3 is minimized. For the same reason, the distribution graph of the second deposition material DM2 and the distribution graph of the fourth deposition material DM4 may similarly match each other because the gap between the second nozzle NZ2 and the fourth nozzle NZ4 is minimized.

In this case, the mixing ratio between the first to fourth deposition materials DM1 to DM4 of emissive layers EML formed on the substrate SUB may be constant. Accordingly, the reliability of pixels PX may be improved.

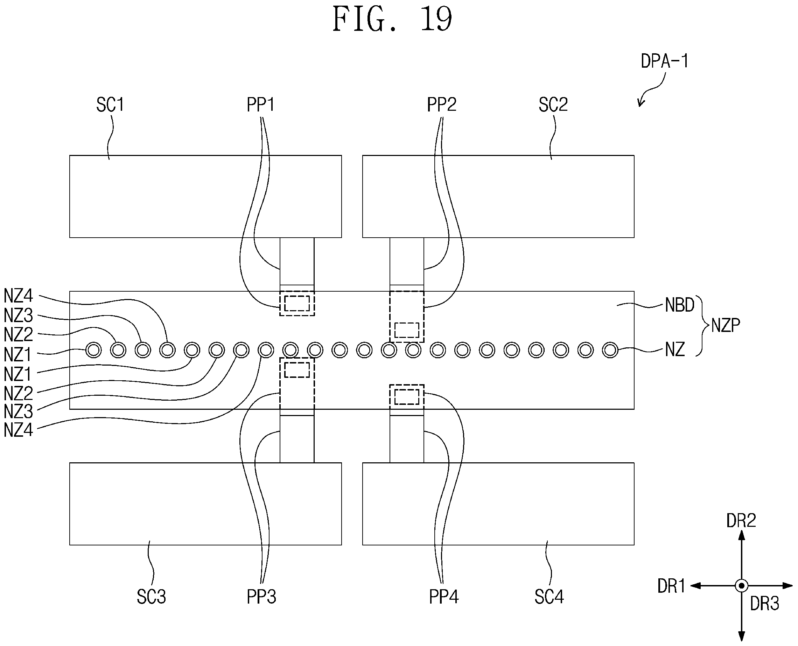

FIG. 19 is a view illustrating a planar configuration of an evaporation device according to an embodiment.

FIG. 19 is a schematic plan view corresponding to FIG. 5. The following description will be focused on the difference between the evaporation device DPA illustrated in FIG. 5 and the evaporation device DPA-1 illustrated in FIG. 19.

Referring to FIG. 19, first, second, third, and fourth nozzles NZ1, NZ2, NZ3, and NZ4 may be arranged in the first direction DR1. The first, second, third, and fourth nozzles NZ1, NZ2, NZ3, and NZ4 may be repeatedly arranged in the first direction DR1 in the order of the first nozzle NZ1, the second nozzle NZ2, the third nozzle NZ3, and the fourth nozzle NZ4.

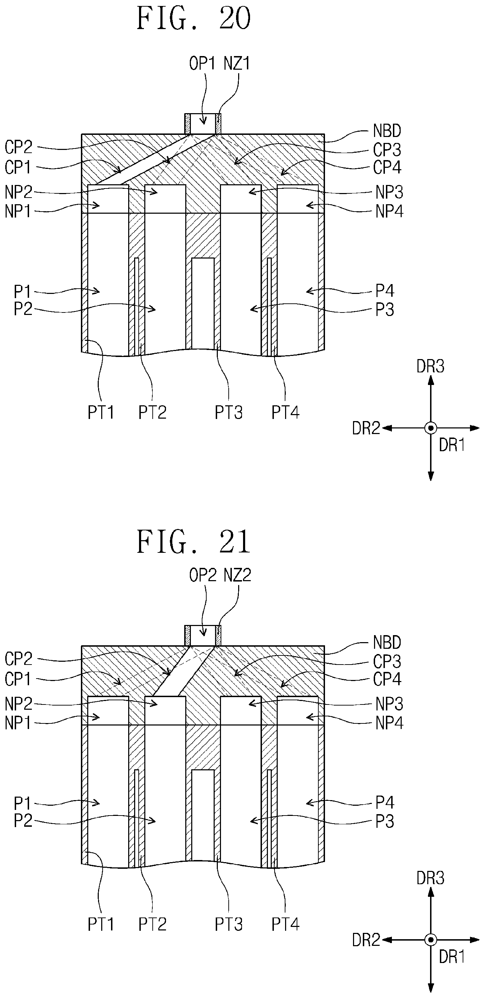

FIGS. 20 to 23 are views illustrating sectional configurations of a nozzle body part and the first, second, third, and fourth nozzles as viewed in the first direction in FIG. 19.

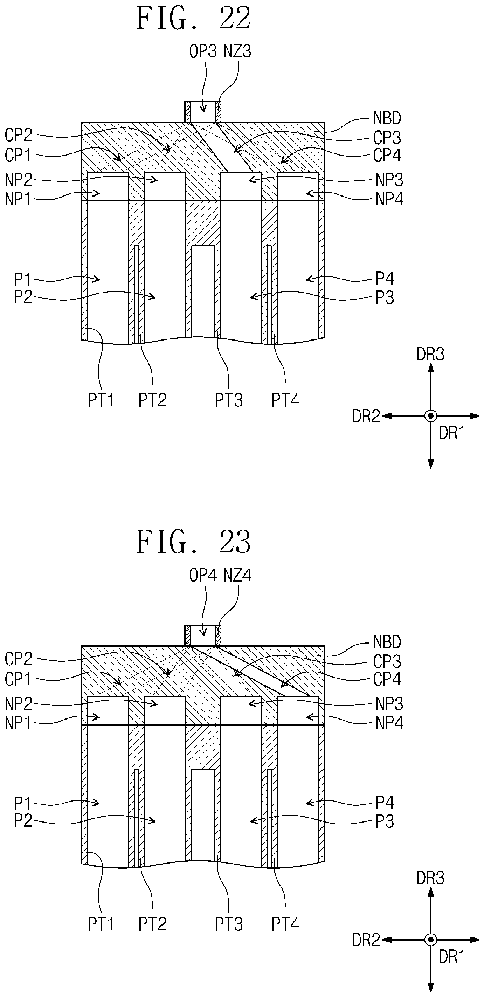

FIGS. 20 to 23 are sectional views corresponding to FIGS. 10 and 11. FIG. 20 is a sectional view of the first nozzle NZ1 as viewed in the first direction DR1, and FIG. 21 is a sectional view of the second nozzle NZ2 as viewed in the first direction DR1. FIG. 22 is a sectional view of the third nozzle NZ3 as viewed in the first direction DR1, and FIG. 23 is a sectional view of the fourth nozzle NZ4 as viewed in the first direction DR1.

Referring to FIG. 20, a first connecting passage CP1 extending from a first nozzle passage NP1 toward the first nozzle NZ1 may be defined in the nozzle body part NBD. A first opening OP1 defined in the first nozzle NZ1 may be defined to be continuous with the first connecting passage CP1. In FIG. 20, second, third, and fourth connecting passages CP2, CP3, and CP4 are illustrated by dotted lines.

Referring to FIG. 21, the second connecting passage CP2 extending from a second nozzle passage NP2 toward the second nozzle NZ2 may be defined in the nozzle body part NBD. A second opening OP2 defined in the second nozzle NZ2 may be defined to be continuous with the second connecting passage CP2. In FIG. 21, the first, third, and fourth connecting passages CP1, CP3, and CP4 are illustrated by dotted lines.

Referring to FIG. 22, the third connecting passage CP3 extending from a third nozzle passage NP3 toward the third nozzle NZ3 may be defined in the nozzle body part NBD. A third opening OP3 defined in the third nozzle NZ3 may be defined to be continuous with the third connecting passage CP3. In FIG. 22, the first, second, and fourth connecting passages CP 1, CP2, and CP4 are illustrated by dotted lines.

Referring to FIG. 23, the fourth connecting passage CP4 extending from a fourth nozzle passage NP4 toward the fourth nozzle NZ4 may be defined in the nozzle body part NBD. A fourth opening OP4 defined in the fourth nozzle NZ4 may be defined to be continuous with the fourth connecting passage CP4. In FIG. 23, the first, second, and third connecting passages CP1, CP2, and CP3 are illustrated by dotted lines.

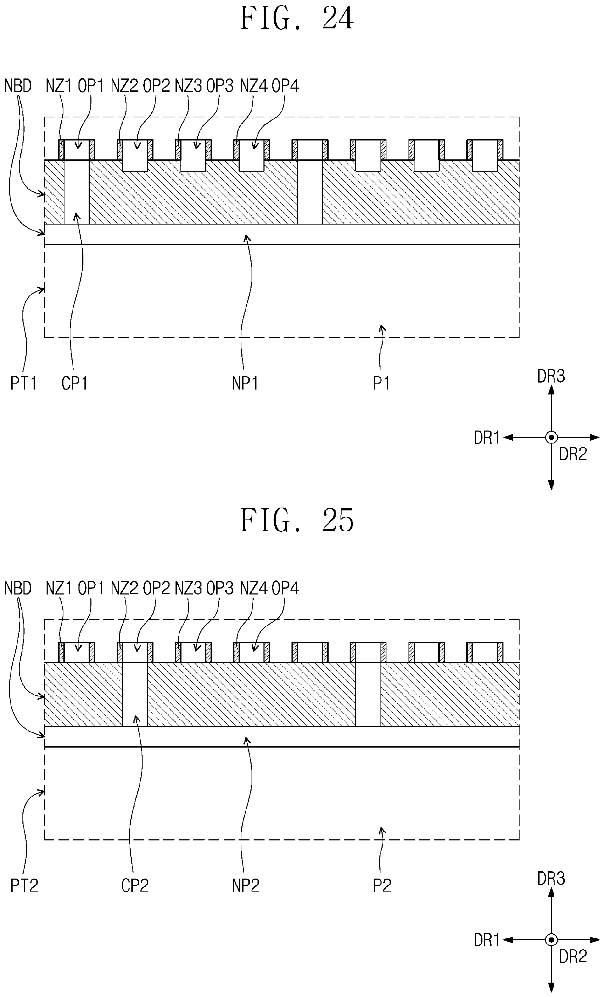

FIGS. 24 to 27 are views illustrating sectional configurations of the nozzle body part and the first, second, third, and fourth nozzles as viewed in the second direction in FIG. 19.

FIGS. 24 to 27 are sectional views corresponding to FIGS. 12 and 13. Sections of eight nozzles NZ among the nozzles NZ illustrated in FIG. 19 are illustrated in FIGS. 24 to 27.

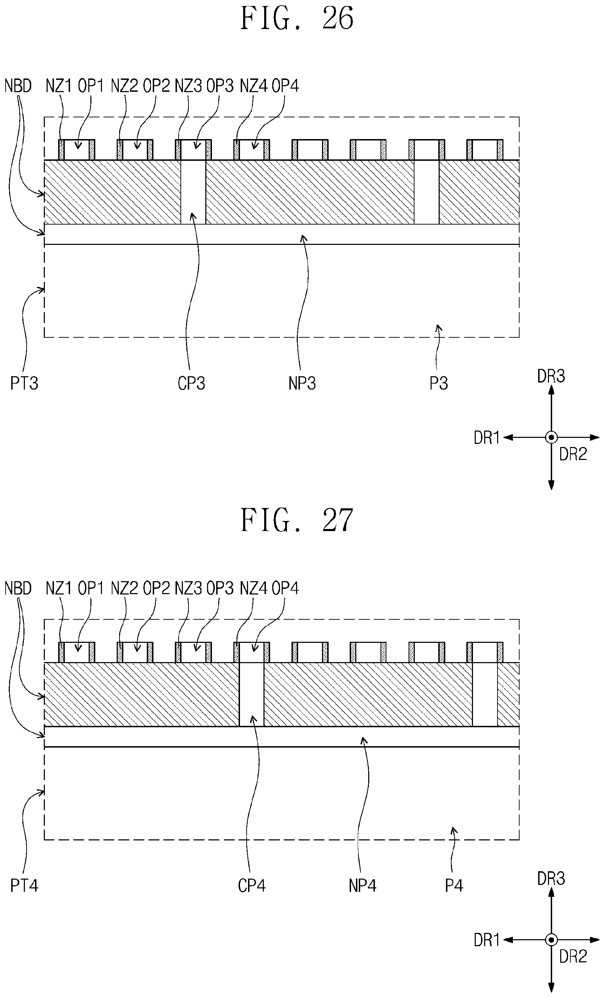

FIG. 24 is a sectional view of the first openings OP1 and the first connecting passages CP1, and FIG. 25 is a sectional view of the second openings OP2 and the second connecting passages CP2. FIG. 26 is a sectional view of the third openings OP3 and the third connecting passages CP3, and FIG. 27 is a sectional view of the fourth openings OP4 and the fourth connecting passages CP4.

Referring to FIG. 24, the plurality of first connecting passages CP1 extending from the first nozzle passage NP1 toward the first nozzles NZ1 may be defined in the nozzle body part NBD. The first openings OP1 may be defined in the first nozzles NZ1 so as be continuous with the first connecting passages CP1.

Referring to FIG. 25, the plurality of second connecting passages CP2 extending from the second nozzle passage NP2 toward the second nozzles NZ2 may be defined in the nozzle body part NBD. The second openings OP2 may be defined in the second nozzles NZ2 so as be continuous with the second connecting passages CP2.

Referring to FIG. 26, the plurality of third connecting passages CP3 extending from the third nozzle passage NP3 toward the third nozzles NZ3 may be defined in the nozzle body part NBD. The third openings OP3 may be defined in the third nozzles NZ3 so as be continuous with the third connecting passages CP3.

Referring to FIG. 27, the plurality of fourth connecting passages CP4 extending from the fourth nozzle passage NP4 toward the fourth nozzles NZ4 may be defined in the nozzle body part NBD. The fourth openings OP4 may be defined in the fourth nozzles NZ4 so as be continuous with the fourth connecting passages CP4.

Referring to FIGS. 24 to 27, the first, second, third, and fourth connecting passages CP1, CP2, CP3, and CP4 may be repeatedly arranged in the order of the first connecting passage CP1, the second connecting passage CP2, the third connecting passage CP3, and the fourth connecting passage CP4 because the first, second, third, and fourth nozzles NZ1, NZ2, NZ3, and NZ4 are repeatedly arranged in the order of the first nozzle NZ1, the second nozzle NZ2, the third nozzle NZ3, and the fourth nozzle NZ4.

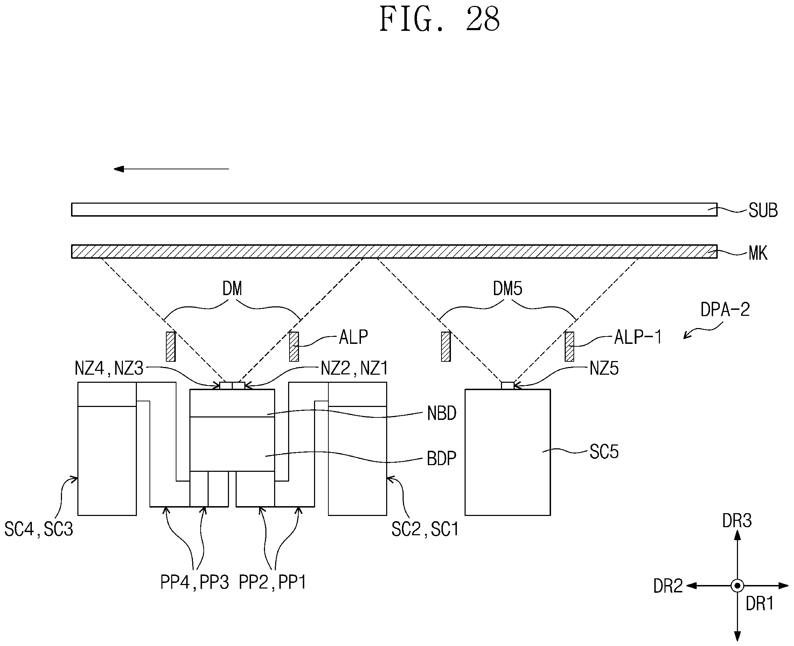

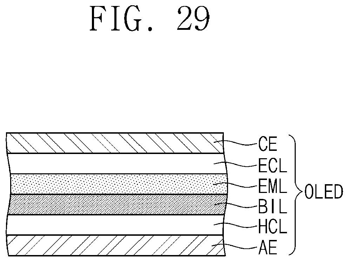

FIG. 28 is a view illustrating a configuration of an evaporation device according to an embodiment. FIG. 29 is a sectional view of a light emitting element capable of being formed using the evaporation device illustrated in FIG. 28.

FIG. 28 is a side view corresponding to FIG. 14.

Referring to FIG. 28, the evaporation device DPA-2 may further include a fifth deposition source SC5 and a fifth nozzle NZ5 in addition to the evaporation device DPA illustrated in FIG. 1. The fifth deposition source SC5 may be spaced apart from first and second deposition sources SC1 and SC2 in the second direction DR2. The first and second deposition sources SC1 and SC2 may be disposed between a body part BDP and the fifth deposition source SC5. A fifth deposition material DM5 may be accommodated in the fifth deposition source SC5.

The fifth nozzle NZ5 may be connected to an upper end of the fifth deposition source SC5. Substantially, a plurality of fifth nozzles NZ5 may be arranged in the first direction and may be provided on the fifth deposition source SC5.

Referring to FIGS. 28 and 29, the fifth deposition material DM5 may include a material for forming an auxiliary hole transport layer BII,. The fifth deposition material DM5 vaporized in the fifth deposition source SC5 may be dispensed onto a substrate SUB through the fifth nozzle NZ5. The dispensing angle of the fifth deposition material DM5 may be limited by an angle limiting plate ALP-1 disposed over the fifth deposition source SC5.

The auxiliary hole transport layer BIL may be formed on a hole control layer HCL before an emissive layer EML is formed. The substrate SUB and a mask MK may move in the first direction DR1, and the fifth deposition material DM5 may be provided on the substrate SUB. Thereafter, a deposition material DM may be provided on the substrate SUB. Accordingly, the auxiliary hole transport layer BIL may be formed on the hole control layer HCL, and thereafter the emissive layer EML may be formed.

The auxiliary hole transport layer BIL and the emissive layer EML may be formed through one process using the evaporation device DPA-2.

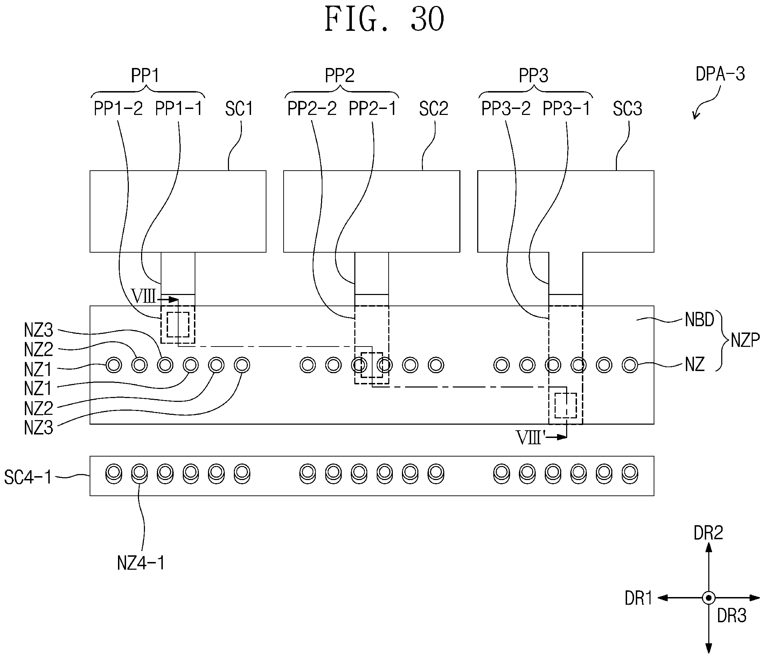

FIG. 30 is a view illustrating a planar configuration of an evaporation device according to an embodiment.

FIG. 30 is a schematic plan view corresponding to FIG. 5. The following description will be focused on the difference between the evaporation device DPA illustrated in FIG. 5 and the evaporation device DPA-3 illustrated in FIG. 30.

Referring to FIG. 30, first, second, and third deposition sources SC1, SC2, and SC3 may be arranged in the first direction DR1. First, second, and third nozzles NZ1, NZ2, and NZ3 may protrude upward from an upper end of a nozzle body part NBD and may be arranged in the first direction DR1. The first, second, and third nozzles NZ1, NZ2, and NZ3 may be repeatedly arranged in the first direction DR1 in the order of the first nozzle NZ1, the second nozzle NZ2, and the third nozzle NZ3.

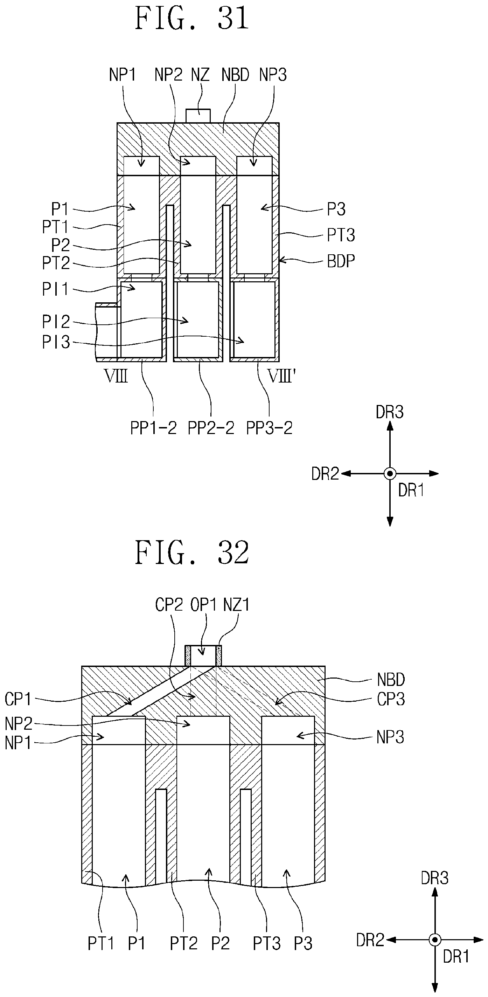

A first pipe PP1, a second pipe PP2, and a third pipe PP3 may be connected to the first deposition source SC1, the second deposition source SC2, and the third deposition source SC3, respectively. The first, second, and third pipes PP1, PP2, and PP3 may be connected to a body part BDP (illustrated in FIG. 31) under or below the nozzle body part NBD.

The first pipe PP1 may include a first-first pipe PP1-1 connected to the first deposition source SC1 and a first-second pipe PP1-2 connected to the body part BDP. The second pipe PP2 may include a second-first pipe PP2-1 connected to the second deposition source SC2 and a second-second pipe PP2-2 connected to the body part BDP. The third pipe PP3 may include a third-first pipe PP3-1 connected to the third deposition source SC3 and a third-second pipe PP3-2 connected to the body part BDP.

The evaporation device DPA-3 may further include a fourth deposition source SC4-1 and a plurality of fourth nozzles NZ4-1 connected to an upper end of the fourth deposition source SC4-1. The fourth deposition source SC4-1 may be spaced apart from the body part BDP and the nozzle body part NBD in the second direction DR2. The body part BDP and the nozzle body part NBD may be disposed between the first, second, and third deposition sources SC1, SC2, and SC3 and the fourth deposition source SC4-1. The fourth nozzles NZ4-1 may be arranged in the first direction DR1.

The above-described first, second, and third deposition materials DM1, DM2, and DM3 may be accommodated in the first, second, and third deposition sources SC1, SC2, and SC3. The above-described fourth deposition material DM4 may be accommodated in the fourth deposition source SC4-1.

FIG. 31 is a sectional view taken along line VIII-VIII' illustrated in FIG. 30.

Referring to FIGS. 30 and 31, the body part BDP may include a first portion PT1, a second portion PT2, and a third portion PT3 arranged in the second direction DR2. The first-second pipe PP1-2 of the first pipe PP1 may be connected to a lower end of the first portion PT1, the second-second pipe PP2-2 of the second pipe PP2 may be connected to a lower end of the second portion PT2, and the third-second pipe PP3-2 of the third pipe PP3 may be connected to a lower end of the third portion PT3.

A first pipe passage PI1 defined in the first-second pipe PP1-2, a first passage P1 defined in the first portion PT1, and a first nozzle passage NP1 defined in the nozzle body part NBD may be continuously defined. A second pipe passage PI2 defined in the second-second pipe PP2-2, a second passage P2 defined in the second portion PT2, and a second nozzle passage NP2 defined in the nozzle body part NBD may be continuously defined. A third pipe passage PI3 defined in the third-second pipe PP3-2, a third passage P3 defined in the third portion PT3, and a third nozzle passage NP3 defined in the nozzle body part NBD may be continuously defined.

FIGS. 32 to 34 are views illustrating sectional configurations of the nozzle body part and the first, second, and third nozzles as viewed in the first direction in FIG. 30.

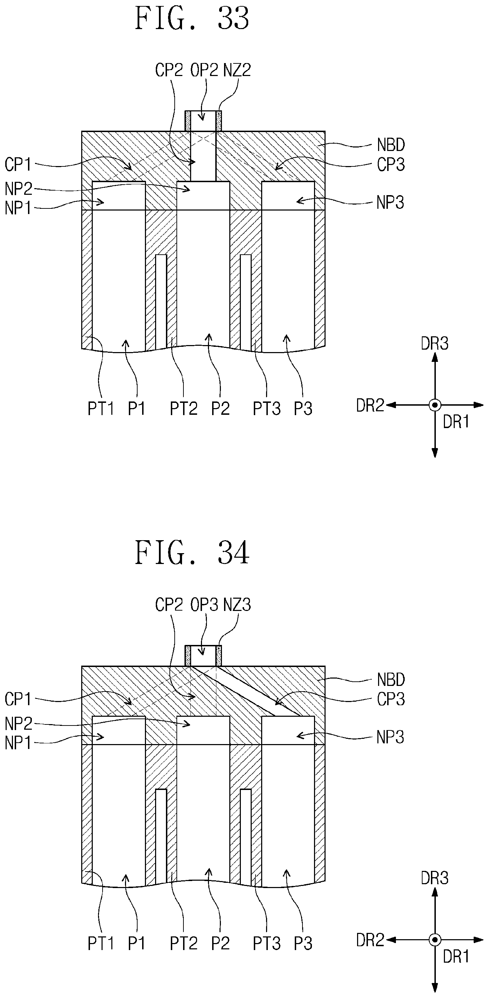

FIGS. 32 to 34 are sectional views corresponding to FIGS. 10 and 11. FIG. 32 is a sectional view of the first nozzle NZ1 as viewed in the first direction DR1, FIG. 33 is a sectional view of the second nozzle NZ2 as viewed in the first direction DR1, and FIG. 34 is a sectional view of the third nozzle NZ3 as viewed in the first direction DR1.

Referring to FIG. 32, a first connecting passage CP1 extending from the first nozzle passage NP1 toward a first opening OP1 of the first nozzle NZ1 may be defined in the nozzle body part NBD. The first opening OP1 may be defined to be continuous with the first connecting passage CP1. In FIG. 32, second and third connecting passages CP2 and CP3 are illustrated by dotted lines.

Referring to FIG. 33, the second connecting passage CP2 extending from the second nozzle passage NP2 toward a second opening OP2 of the second nozzle NZ2 may be defined in the nozzle body part NBD. The second opening OP2 may be defined to be continuous with the second connecting passage CP2. In FIG. 33, the first and third connecting passages CP1 and CP3 are illustrated by dotted lines.

Referring to FIG. 34, the third connecting passage CP3 extending from the third nozzle passage NP3 toward a third opening OP3 of the third nozzle NZ3 may be defined in the nozzle body part NBD. The third opening OP3 may be defined to be continuous with the third connecting passage CP3. In FIG. 34, the first and second connecting passages CP1 and CP2 are illustrated by dotted lines.

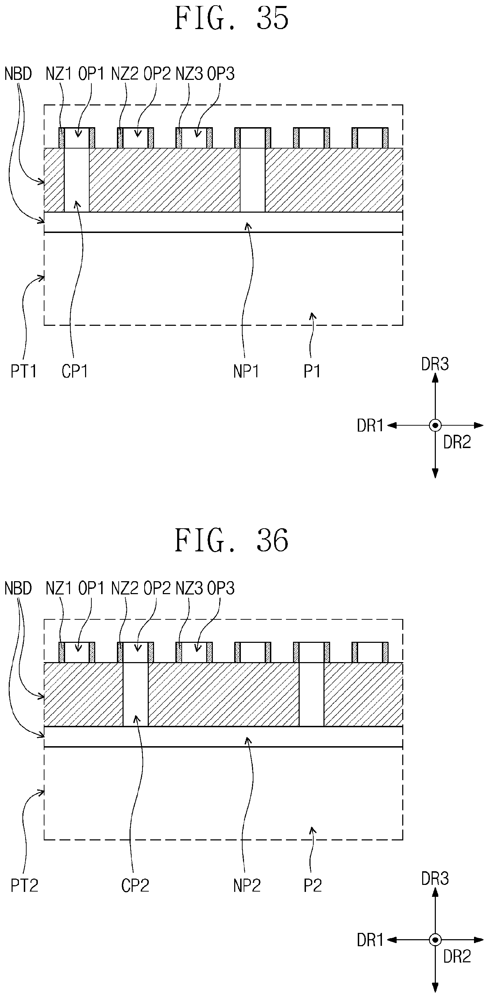

FIGS. 35 to 37 are views illustrating sectional configurations of the nozzle body part and the first, second, and third nozzles as viewed in the second direction in FIG. 30.

FIGS. 35 to 37 are sectional views corresponding to FIGS. 12 and 13. Sections of six nozzles NZ among the nozzles NZ illustrated in FIG. 30 are illustrated in FIGS. 35 to 37.

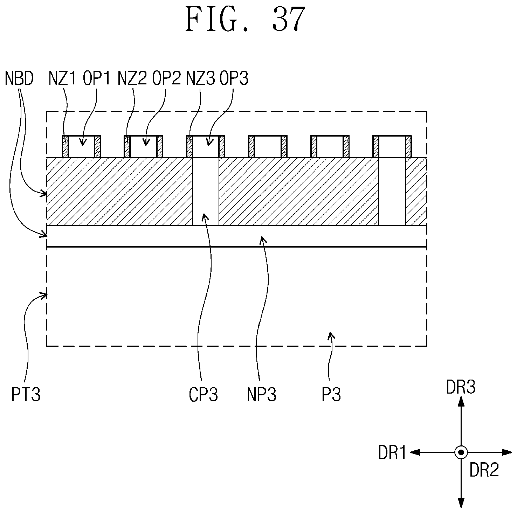

FIG. 35 is a sectional view of the first openings OP1 and the first connecting passages CP1, FIG. 36 is a sectional view of the second openings OP2 and the second connecting passages CP2, and FIG. 37 is a sectional view of the third openings OP3 and the third connecting passages CP3.

Referring to FIG. 35, the plurality of first connecting passages CP1 extending from the first nozzle passage NP1 toward the first openings OP1 of the first nozzles NZ1 may be defined in the nozzle body part NBD.

Referring to FIG. 36, the plurality of second connecting passages CP2 extending from the second nozzle passage NP2 toward the second openings OP2 of the second nozzles NZ2 may be defined in the nozzle body part NBD.

Referring to FIG. 37, the plurality of third connecting passages CP3 extending from the third nozzle passage NP3 toward the third openings OP3 of the third nozzles NZ3 may be defined in the nozzle body part NBD.

Referring to FIGS. 35 to 37, the first, second, and third connecting passages CP1, CP2, and CP3 may be repeatedly arranged in the order of the first connecting passage CP1, the second connecting passage CP2, and the third connecting passage CP3 because the first, second, and third nozzles NZ1, NZ2, and NZ3 are repeatedly arranged in the order of the first nozzle NZ1, the second nozzle NZ2, and the third nozzle NZ3.

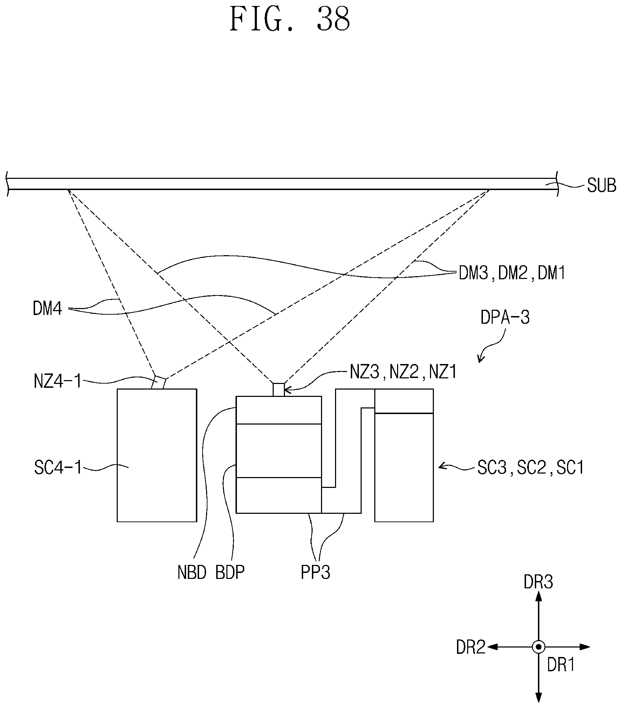

FIG. 38 is a view illustrating deposition materials dispensed onto a substrate from the evaporation device illustrated in FIG. 30.

FIG. 38 is a side view of the evaporation device as viewed in the first direction DR1. In FIG. 38, a mask MK is omitted. A side surface of the evaporation device DPA-3 in a state in which the third nozzle NZ3 and the third deposition source SC3 are viewed is illustrated, and for convenience of description, the reference numerals of the first and second nozzles NZ1 an NZ2 and the first and second deposition sources SC1 and SC2 are illustrated together.

Referring to FIGS. 30 and 38, the first, second, and third deposition materials DM1, DM2, and DM3 may be dispensed toward the substrate SUB from the first, second, and third nozzles NZ1, NZ2, and NZ3. The fourth deposition material DM4 vaporized in the fourth deposition source SC4-1 may be dispensed toward the substrate SUB through the fourth nozzles NZ4-1.

The fourth nozzles NZ4-1 may be obliquely disposed toward the first, second, and third nozzles NZ1, NZ2, and NZ3. In this case, the deposition region (reference numeral not illustrated) of the substrate SUB on which the first, second, and third deposition materials DM1, DM2, and DM3 dispensed from the first, second, and third nozzles NZ1, NZ2, and NZ3 are provided may be substantially the same as the deposition region (reference numeral not illustrated) of the substrate SUB on which the fourth deposition material DM4 dispensed from the fourth nozzles NZ4-1 is provided.

In FIG. 18, the first deposition material DM1 and the second deposition material DM2 dispensed from the first and second nozzles NZ1 and NZ2 may be provided on the same first deposition region DA1. For example, the first deposition material M1 and the second deposition material M2 may be dispensed onto the substrate SUB at a selectable ratio.

Likewise, even in FIG. 38, the first to fourth deposition materials DM1, DM2, DM3, and DM4 may be provided on the same deposition region. Accordingly, the first to fourth deposition materials DM1, DM2, DM3, and DM4 may be provided on the substrate SUB at a selectable ratio.

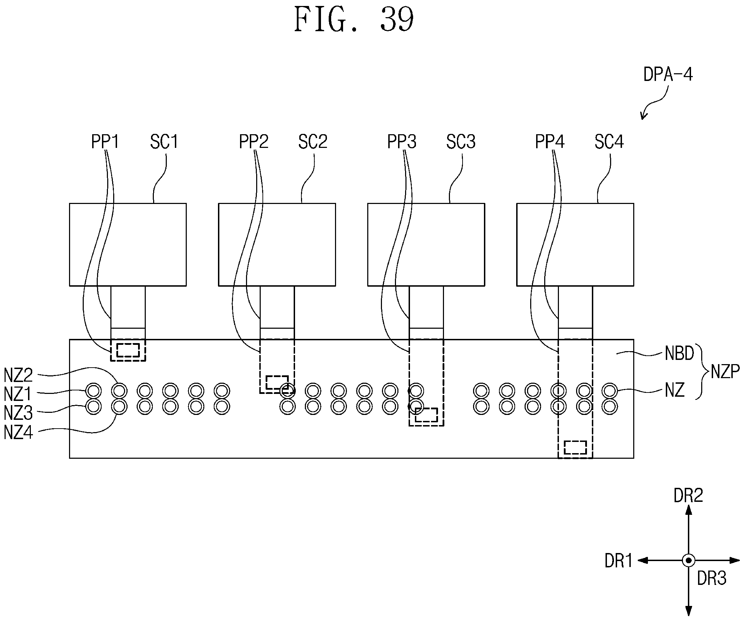

FIG. 39 is a view illustrating a planar configuration of an evaporation device according to an embodiment.

FIG. 39 is a schematic plan view corresponding to FIG. 5. The following description will be focused on the difference between the evaporation device DPA illustrated in FIG. 5 and the evaporation device DPA-4 illustrated in FIG. 39.

Referring to FIG. 39, first, second, third, and fourth deposition sources SC1, SC2, SC3, and SC4 may be arranged in the first direction DR1. The evaporation device DPA-4 may be substantially the same as the evaporation device DPA, except for the arrangement of the first, second, third, and fourth deposition sources SC1, SC2, SC3, and SC4.

For example, as in FIG. 9, first, second, third, and fourth pipes PP1, PP2, PP3, and PP4 may be connected to first, second, third, and fourth portions PT1, PT2, PT3, and PT4 of a body part BDP, respectively. As in FIGS. 10 and 11, first to fourth passages P1 to P4 may be defined in the first to fourth portions PT1 to PT4 of the body part BDP, and first to fourth nozzle passages NP1 to NP4 and first to fourth connecting passages CP1 to CP4 may be defined in a nozzle body part NBD.

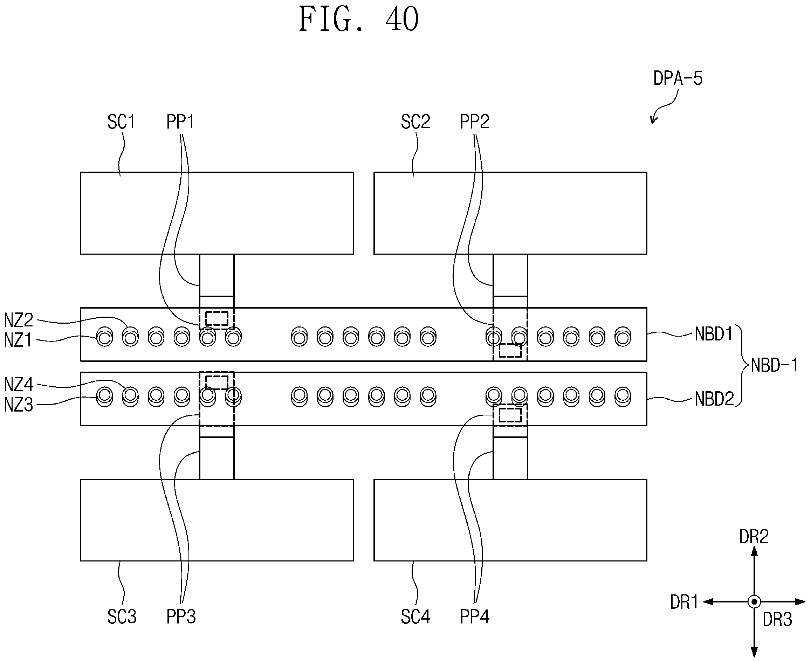

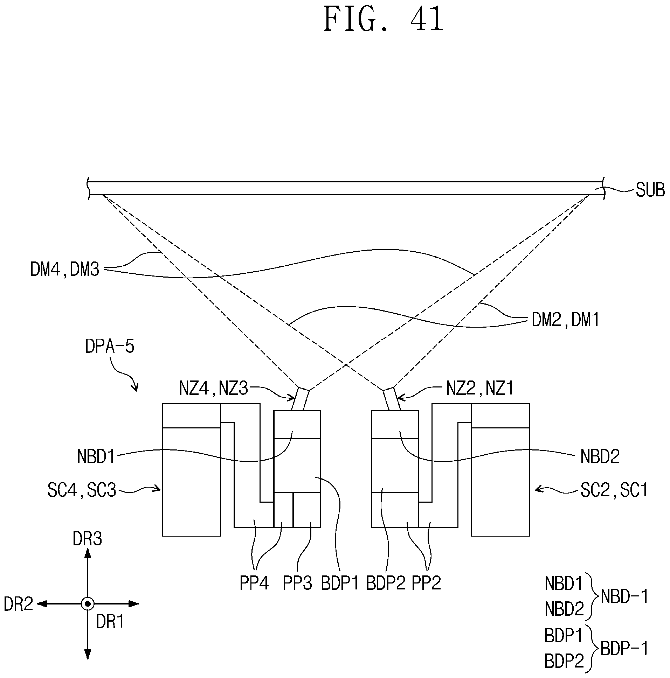

FIG. 40 is a view illustrating a planar configuration of an evaporation device according to an embodiment. FIG. 41 is a view illustrating deposition materials dispensed onto a substrate from the evaporation device illustrated in FIG. 40.

FIG. 40 is a schematic plan view corresponding to FIG. 5. FIG. 41 is a side view corresponding to FIG. 38. In FIG. 41, a mask MK is omitted. The following description will be focused on the difference between the evaporation device DPA illustrated in FIG. 5 and the evaporation device DPA-5 illustrated in FIG. 40.

Referring to FIGS. 40 and 41, a body part BDP-1 may include a first body part BDP1 and a second body part BDP2. A nozzle body part NBD-1 may include a first nozzle body part NBD1 disposed on the first body part BDP1 and a second nozzle body part NBD2 disposed on the second body part BDP2. Substantially, the first and second body parts BDP1 and BDP2 and the first and second nozzle body parts NBD1 and NBD2 may correspond to a structure in which the body part BDP illustrated in FIG. 5 is divided into two parts and the nozzle body part NBD illustrated in FIG. 5 is divided into two parts.

For example, the structure of the first body part BDP1 may substantially correspond to the portion of the body part BDP that may include the first portion PT1 and the second portion PT2 in which the first passage P1 and the second passage P2 are defined in FIGS. 7 to 11. The structure of the second body part BDP2 may substantially correspond to the portion of the body part BDP that may include the third portion PT3 and the fourth portion PT4 in which the third passage P3 and the fourth passage P4 are defined in FIGS. 7 to 11.

Accordingly, a first pipe PP1 and a second pipe PP2 may be connected to the first body part BDP1, and a third pipe PP3 and a fourth pipe PP4 may be connected to the second body part BDP2.

The structure of the first nozzle body part NBD1 may substantially correspond to the portion of the nozzle body part NBD in which the first nozzle passage NP1, the second nozzle passage NP2, the first connecting passage CP1, and the second connecting passage CP2 are defined in FIGS. 7 to 11. The structure of the second nozzle body part NBD2 may substantially correspond to the portion of the nozzle body part NBD in which the third nozzle passage NP3, the fourth nozzle passage NP4, the third connecting passage CP3, and the fourth connecting passage CP4 are defined in FIGS. 7 to 11.

Accordingly, first and second nozzles NZ1 and NZ2 may protrude upward from an upper end of the first nozzle body part NBD1, and third and fourth nozzles NZ3 and NZ4 may protrude upward from an upper end of the second nozzle body part NBD2.

The first body part BDP1 may be disposed between first and second deposition sources SC1 and SC2 and the second body part BDP2 in the second direction DR2. The first nozzle body part NBD1 may be disposed between the first and second deposition sources SC1 and SC2 and the second nozzle body part NBD2 in the second direction DR2.

The second body part BDP2 may be disposed between the first body part BDP1 and third and fourth deposition sources SC3 and SC4 in the second direction DR2. The second nozzle body part NBD2 may be disposed between the first nozzle body part NBD1 and the third and fourth deposition sources SC3 and SC4 in the second direction DR2.

Referring to FIG. 41, the first and second nozzles NZ1 and NZ2 and the third and fourth nozzles NZ3 and NZ4 may be obliquely disposed to face toward each other. First and second deposition materials DM1 and DM2 may be dispensed toward the substrate SUB from the first and second nozzles NZ1 and NZ2. Third and fourth deposition materials DM3 and DM4 may be dispensed toward the substrate SUB from the third and fourth nozzles NZ3 and NZ4.

In case that the first and second nozzles NZ1 and NZ2 and the third and fourth nozzles NZ3 and NZ4 are obliquely disposed to face toward each other, the deposition region (reference numeral not illustrated) of the substrate SUB on which the first and second deposition materials DM1 and DM2 dispensed from the first and second nozzles NZ1 and NZ2 are provided may be substantially the same as the deposition region (reference numeral not illustrated) of the substrate SUB on which the third and fourth deposition materials DM3 and DM4 dispensed from the third and fourth nozzles NZ3 and NZ4 are provided. In this case, as described above, the first to fourth deposition materials DM1, DM2, DM3, and DM4 may be provided on the substrate SUB at a selectable ratio.

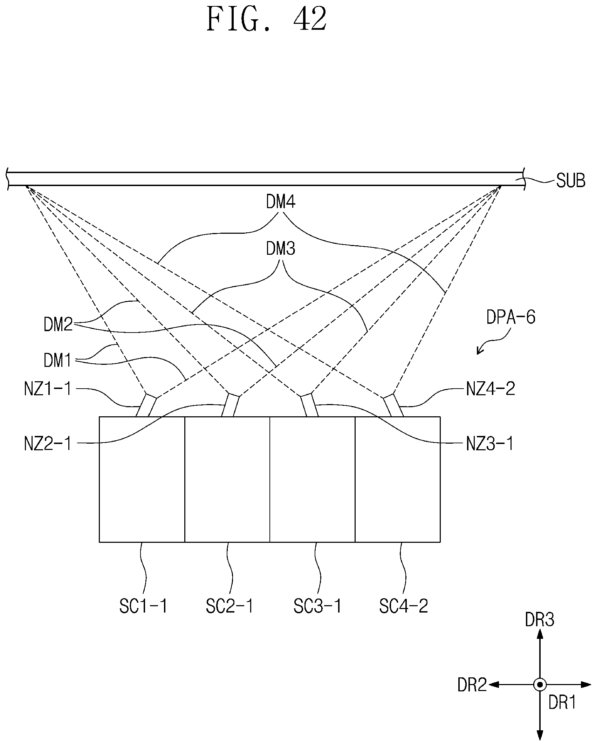

FIG. 42 is a view illustrating deposition materials dispensed onto a substrate from an evaporation device according to an embodiment.

FIG. 42 is a side view corresponding to FIG. 38. FIG. 42 is a side view of the evaporation device as viewed in the first direction DR1.

Referring to FIG. 42, the evaporation device DPA-6 may include a first deposition source SC1-1, a second deposition source SC2-1, a third deposition source SC3-1, a fourth deposition source SC4-2, and a plurality of first, second, third, and fourth nozzles NZ1-1, NZ2-1, NZ3-1, and NZ4-2.

The first deposition source SC1-1, the second deposition source SC2-1, the third deposition source SC3 -1, and the fourth deposition source SC4-2 may be arranged in the second direction DR2. A first deposition material DM1 may be accommodated in the first deposition source SC1-1, and a second deposition material DM2 may be accommodated in the second deposition source SC2-1. A third deposition material DM3 may be accommodated in the third deposition source SC3-1, and a fourth deposition material DM4 may be accommodated in the fourth deposition source SC4-2.

The first nozzle NZ1-1 may be disposed on the first deposition source SC1-1. Although one first nozzle NZ1-1 is illustrated in the side view, a plurality of first nozzles NZ1-1 arranged in the first direction DR1 may be disposed on the first deposition source SC1-1. The second nozzle NZ2-1 may be disposed on the second deposition source SC2-1. Although one second nozzle NZ2-1 is illustrated in the side view, a plurality of second nozzles NZ2-1 arranged in the first direction DR1 may be disposed on the second deposition source SC2-1.

The third nozzle NZ3-1 may be disposed on the third deposition source SC3-1. Although one third nozzle NZ3-1 is illustrated in the side view, a plurality of third nozzles NZ3-1 arranged in the first direction DR1 may be disposed on the third deposition source SC3-1. The fourth nozzle NZ4-2 may be disposed on the fourth deposition source SC4-2. Although one fourth nozzle NZ4-2 is illustrated in the side view, a plurality of fourth nozzles NZ4-2 arranged in the first direction DR1 may be disposed on the fourth deposition source SC4-2.

The second nozzle NZ2-1 and the third nozzle NZ3-1 may be obliquely disposed to face toward each other and may be symmetrical to each other. The first nozzle NZ1-1 and the fourth nozzle NZ4-2 may be obliquely disposed to face toward each other and may be symmetrical to each other. The slopes of the first and fourth nozzles NZ1-1 and NZ4-2 may be greater than the slopes of the second and third nozzles NZ2-1 and NZ3-1.

Depending on the structure of the first, second, third, and fourth nozzles NZ1-1, NZ2-1, NZ3-1, and NZ4-2, the deposition region (reference numeral not illustrated) of the substrate SUB on which the first deposition material DM1 dispensed from the first nozzle NZ1-1 is provided, the deposition region (reference numeral not illustrated) of the substrate SUB on which the second deposition material DM2 dispensed from the second nozzle NZ2-1 is provided, the deposition region (reference numeral not illustrated) of the substrate SUB on which the third deposition material DM3 dispensed from the third nozzle NZ3-1 is provided, and the deposition region (reference numeral not illustrated) of the substrate SUB on which the fourth deposition material DM4 dispensed from the fourth nozzle NZ4-2 is provided may be substantially the same as one another. In this case, as described above, the first to fourth deposition materials DM1, DM2, DM3, and DM4 may be provided on the substrate SUB at a selectable ratio.

According to the embodiments, the nozzles of the evaporation device arranged in the different rows may be disposed as close as possible to each other to make contact with each other. Accordingly, the mixing ratio between the deposition materials provided on the substrate may be constant.

While the disclosure has been described with reference to embodiments thereof, it will be apparent to those of ordinary skill in the art that various changes and modifications may be made thereto without departing from the scope of the disclosure and as set forth in the following claims.

## Claims

1. An evaporation device comprising:
a first deposition source;
a second deposition source disposed in a first direction together with the first deposition source;
a body part spaced apart from the first deposition source and the second deposition source in a second direction intersecting the first direction, the body part including a first portion and a second portion disposed in the second direction;
a nozzle body part disposed on the body part;
a first pipe connected to a side surface of the first deposition source facing the body part and the nozzle body part and a lower end of the first portion;
a second pipe connected to a side surface of the second deposition source facing the body part and the nozzle body part and a lower end of the second portion;
a first nozzle protruding upward from the nozzle body part; and
a second nozzle protruding upward from the nozzle body part.

2. The evaporation device of claim 1, wherein the first nozzle and the second nozzle are disposed in the first direction.

3. The evaporation device of claim 1 or 2, wherein
a first pipe passage is defined in the first pipe, and a first passage continuous with the first pipe passage is defined in the first portion, and
a second pipe passage is defined in the second pipe, and a second passage continuous with the second pipe passage is defined in the second portion.

4. The evaporation device of claim 3, wherein
a first nozzle passage continuous with the first passage and a second nozzle passage continuous with the second passage are defined in the nozzle body part, and
a first opening continuous with the first nozzle passage is defined in the first nozzle, and a second opening continuous with the second nozzle passage is defined in the second nozzle.

5. The evaporation device of any preceding claim, wherein
the first pipe includes:
a first-first pipe connected to an upper portion of the side surface of the first deposition source and extending downward; and
a first-second pipe connected to a lower portion of the first-first pipe and the lower end of the first portion, and
the second pipe includes:
a second-first pipe connected to an upper portion of the side surface of the second deposition source and extending downward; and
a second-second pipe connected to a lower portion of the second-first pipe and the lower end of the second portion.

6. The evaporation device of any preceding claim, further comprising:
a third deposition source; and
a fourth deposition source disposed in the first direction together with the third deposition source, wherein
the third deposition source and the fourth deposition source are spaced apart from the first deposition source and the second deposition source in the second direction, and
the body part and the nozzle body part are disposed between the first deposition source and the second deposition source and the third deposition source and the fourth deposition source.

7. The evaporation device of claim 6, wherein different deposition materials are accommodated in the first deposition source, the second deposition source, the third deposition source, and the fourth deposition source, respectively.

8. The evaporation device of claim 6 or 7, further comprising:
a third pipe connected to a side surface of the third deposition source facing the body part and the nozzle body part and a lower end of the body part;
a fourth pipe connected to a side surface of the fourth deposition source facing the body part and the nozzle body part and the lower end of the body part;
a third nozzle protruding upward from the nozzle body part; and
a fourth nozzle protruding upward from the nozzle body part.

9. The evaporation device of claim 8, wherein the third nozzle and the fourth nozzle are disposed in the first direction and disposed adjacent to the first nozzle and the second nozzle in the second direction, respectively, and optionally
the third nozzle and the fourth nozzle directly contact the first nozzle and the second nozzle in the second direction, respectively.

10. The evaporation device of claim 8 or 9, wherein
the body part further includes a third portion and a fourth portion disposed in the second direction together with the first portion and the second portion, and
the third pipe is connected to a lower end of the third portion, and the fourth pipe is connected to a lower end of the fourth portion, and optionally
a third pipe passage is defined in the third pipe, and a third passage continuous with the third pipe passage is defined in the third portion,
a fourth pipe passage is defined in the fourth pipe, and a fourth passage continuous with the fourth pipe passage is defined in the fourth portion,
a third nozzle passage continuous with the third passage and a fourth nozzle passage continuous with the fourth passage are defined in the nozzle body part, and
a third opening continuous with the third nozzle passage is defined in the third nozzle, and a fourth opening continuous with the fourth nozzle passage is defined in the fourth nozzle.

11. The evaporation device of any one of claims 8 to 10, wherein the first nozzle, the second nozzle, the third nozzle, and the fourth nozzle are disposed in the first direction.

12. The evaporation device of claim 6 or any claim dependent on claim 6, further comprising:
a fifth deposition source spaced apart from the first deposition source and the second deposition source in the second direction; and
a fifth nozzle connected to an upper end of the fifth deposition source,
wherein the first deposition source and the second deposition source are disposed between the body part and the fifth deposition source.

13. The evaporation device of any one of claims 1 to 5, further comprising:
a third deposition source disposed in the first direction together with the first deposition source and the second deposition source;
a third pipe connected to the third deposition source and a third portion of the body part;
a third nozzle protruding upward from the nozzle body part;
a fourth deposition source spaced apart from the nozzle body part in the second direction; and
a plurality of fourth nozzles connected to an upper end of the fourth deposition source and disposed in the first direction,
wherein the body part is disposed between the first deposition source, the second deposition source, and the third deposition source and the fourth deposition source, and optionally
the first nozzle, the second nozzle, and the third nozzle are disposed in the first direction, and
the plurality of fourth nozzles are obliquely disposed to face toward the first nozzle, the second nozzle, and the third nozzle.

14. The evaporation device of any one of claims 1 to 5, further comprising:
a third deposition source;
a fourth deposition source;
a third pipe connected to the third deposition source and the body part;
a fourth pipe connected to the fourth deposition source and the body part;
a third nozzle protruding upward from the nozzle body part; and
a fourth nozzle protruding upward from the nozzle body part,
wherein the first deposition source, the second deposition source, the third deposition source, and the fourth deposition source are disposed in the first direction.

15. The evaporation device of any one of claims 1 to 5, further comprising:
a third deposition source;
a fourth deposition source disposed in the first direction together with the third deposition source;
a third pipe connected to the third deposition source;
a fourth pipe connected to the fourth deposition source; and
a third nozzle and a fourth nozzle disposed in the first direction, wherein
the body part includes:
a first body part connected to the first pipe and the second pipe; and
a second body part connected to the third pipe and the fourth pipe,
the nozzle body part includes:
a first nozzle body part from which the first nozzle and the second nozzle protrude, the first nozzle body part being disposed on the first body part; and
a second nozzle body part disposed on the second body part,
the third nozzle and the fourth nozzle protrude upward from the second nozzle body part, and
the first body part is disposed between the first deposition source and the second deposition source and the second body part in the second direction, and the second body part is disposed between the first body part and the third deposition source and the fourth deposition source in the second direction, and optionally
the first nozzle and the second nozzle and the third nozzle and the fourth nozzle are obliquely disposed to face toward each other.
